# EUROPEAN PATENT APPLICATION

(11) **EP 4 827 256 A1**
(43) Date of publication of application: **21.10.2026**
(21) Application number: 25797547.4
(22) Date of filing: 24.04.2025
(51) Int. Cl.: H05K 7/20, H02M 7/00

(54) **POWER CONVERSION APPARATUS**

(30) Priority: 30.04.2024 CN 202410564999
(71) Applicant: Huawei Digital Power Technologies Co., Ltd., Shenzhen, Guangdong 518043 (CN)
(72) Inventor: REN, Junheng, Shenzhen, Guangdong 518043 (CN); LI, Jiyang, Shenzhen, Guangdong 518043 (CN); HONG, Fangjun, Shenzhen, Guangdong 518043 (CN); SUN, Faming, Shenzhen, Guangdong 518043 (CN)
(74) Representative: Maiwald GmbH
(86) International application number: PCT/CN2025/091040
(87) International publication number: WO 2025/228241

(57) **Abstract**

Embodiments of this application provide a power conversion device, and relate to the field of power electronics technologies. The power conversion device includes a housing, a circuit board, a heat sink, and a first heat exchanger. A power cavity is formed inside the housing. A heat dissipation cavity is formed outside the housing. The housing includes a separator located between the power cavity and the heat dissipation cavity. The separator is provided with an opening. The circuit board is disposed in the power cavity. A first power component is disposed on a side that is of the circuit board and that faces the opening. The heat sink is disposed in the heat dissipation cavity and includes a first substrate and a first heat dissipation portion. The first substrate is disposed at the opening and is in contact with the first power component. A first gas-liquid channel is disposed in the first substrate. A second gas-liquid channel communicating with the first gas-liquid channel is disposed in the first heat dissipation portion. A cooling medium used for gas-liquid conversion is disposed in the first gas-liquid channel. The first heat exchanger is located in the power cavity or the heat dissipation cavity. According to the foregoing technical solution, targeted heat dissipation can be performed on a component that heats up severely in the power conversion device, so that the power conversion device operates stably.

## Description

This application claims priority to Chinese Patent Application No. 202410564999.6, filed with the China National Intellectual Property Administration on April 30, 2024 and entitled "POWER CONVERSION DEVICE", which is incorporated herein by reference in its entirety.

### TECHNICAL FIELD

This application relates to the field of power electronics technologies, and in particular, to a power conversion device.

### BACKGROUND

An inverter is a power conversion device that can convert a direct current into an alternating current. A power conversion device like an inverter heats up severely during use. The progress of the times leads to a sharp increase in a demand for heat dissipation of power conversion devices such as inverters.

In a related technology, overall heat dissipation is performed on an entire power conversion device. However, the power conversion device includes a plurality of high-power components, such as a high-power chip. Such components heat up severely. Through the heat dissipation method in the related technology, the heat of such components cannot be accurately dissipated, resulting in impact on operating stability of the power conversion device.

### SUMMARY

This application provides a power conversion device. Targeted heat dissipation can be performed on a component that heats up severely in the power conversion device, so that the power conversion device can operate stably.

To achieve the foregoing objective, this application uses the following technical solutions.

This application provides a power conversion device. The power conversion device includes a housing, a circuit board, a heat sink, and a first heat exchanger. A sealed power cavity is formed inside the housing. An open and ventilated heat dissipation cavity is formed outside the housing. The housing includes a separator located between the power cavity and the heat dissipation cavity. A protection rating of the power cavity is higher than that of the heat dissipation cavity. The separator is provided with an opening. The circuit board is disposed in the power cavity. A first power component is mounted on a side that is of the circuit board and that faces the opening. The first power component forms a power conversion circuit of the power conversion device, to perform power conversion on a direct current input to the power conversion device. The heat sink is disposed in the heat dissipation cavity and includes a first substrate and a first heat dissipation portion. The first substrate is disposed at the opening and is in thermal contact with the first power component in the power cavity. The first heat dissipation portion extends outward from the first substrate. A first gas-liquid channel is disposed in the first substrate. A second gas-liquid channel communicating with the first gas-liquid channel is disposed in the first heat dissipation portion. A cooling medium used for gas-liquid conversion is disposed in the first gas-liquid channel. An included angle between the first gas-liquid channel and the second gas-liquid channel is 90 degrees or is greater than 90 degrees and less than 180 degrees. An electronic component is mounted on a side that is of the circuit board and that is opposite to the side on which the first power component is mounted. The first heat exchanger is located in the power cavity or the heat dissipation cavity. The first heat exchanger is configured to transfer heat in the power cavity to the heat dissipation cavity, to dissipate heat for the electronic component.

When the first power component in the power conversion device heats up severely, the heat of the first power component is transferred to the first substrate, and the cooling medium in the first substrate is heated. After the liquid cooling medium in the first gas-liquid channel is heated up, at least a part of the cooling medium becomes gaseous. The gaseous cooling medium flows (rises) to the second gas-liquid channel of the first heat dissipation portion. The open and ventilated heat dissipation cavity facilitates heat exchange between the cooling medium in the first heat dissipation portion and the outside, so that the gaseous cooling medium quickly undergoes heat dissipation and condenses in the first heat dissipation portion, gradually changes back to the liquid cooling medium, and then flows back to the first substrate. In this way, heat is continuously dissipated for the first power component. In this application, targeted heat dissipation is performed on a component (for example, the first power component) that heats up severely, so that the power conversion device can operate stably. A specific angle is formed between the first gas-liquid channel and the second gas-liquid channel, so that the cooling medium can smoothly return under gravity to a position that is in the first substrate and that is close to a part in thermal contact with the first power component.

The power cavity is sealed and has a higher protection rating than the heat dissipation cavity, so that a possibility that external impurities enter the power cavity can be reduced. In addition, the first substrate is disposed at the opening, so that the first substrate can be in contact with the first power component and shield the opening, to further reduce a possibility of mutual interference between the heat dissipation cavity and the power cavity. In this way, the circuit board can be disposed in a cavity with a relatively strong protection capability, to ensure safety of another component and reduce a risk of a fault in the power conversion device while dissipating heat of a heat-generating component.

The circuit board is disposed in the power cavity. When the power conversion device operates, the circuit board and the electronic component on the circuit board heat up severely, so that a temperature in the power cavity is high. The first heat exchanger is disposed so that hot air in the power cavity can exchange heat with cold air in the heat dissipation cavity, to reduce the temperature in the power cavity and enable the power conversion device to operate stably.

In an optional implementation, the first substrate extends in a vertical direction and protrudes from the first heat dissipation portion, and the first power component is in thermal contact with a part that is of the first substrate and that protrudes from the first heat dissipation portion.

In the foregoing design manner, the first heat dissipation portion and the first power component can have a small overlapping region, so that the first heat dissipation portion has a larger region for heat exchange with air in the heat dissipation cavity. This reduces impact of the heat of the first power component on condensation of the cooling medium in the first heat dissipation portion, enables the cooling medium to quickly condense in the first heat dissipation portion, and helps improve heat dissipation effect of the heat sink.

In an optional implementation, the first heat exchanger is located in the power cavity. A first heat exchange channel is formed in the first heat exchanger. The first heat exchange channel is isolated from the power cavity. The first heat exchange channel has an inlet and an outlet that are provided on the first heat exchanger. Both the inlet and the outlet of the first heat exchange channel communicate with the heat dissipation cavity.

The air in the heat dissipation cavity may enter the first heat exchange channel, and then exchange heat with the hot air in the power cavity through the first heat exchanger. In addition, the heat dissipation cavity is open and ventilated. In this way, external air can continuously enter the first heat exchange channel, to reduce the temperature in the power cavity and enable the power conversion device to operate stably.

In an optional implementation, the first heat exchanger is located in the heat dissipation cavity. A first heat exchange channel is formed in the first heat exchanger. The first heat exchange channel is isolated from the heat dissipation cavity. The first heat exchange channel has an inlet and an outlet that are provided on the first heat exchanger. Both the inlet and the outlet of the first heat exchange channel communicate with the power cavity.

The first heat exchanger may enable the hot air in the power cavity to enter the first heat exchange channel, and then exchange heat with the air in the heat dissipation cavity in the first heat exchanger. The heat dissipation cavity is set to an open and ventilated structure, so that the air in the first heat exchange channel exchanges heat with sufficient external cold air, to reduce the temperature in the power cavity and enable the power conversion device to operate stably. In addition, the first heat exchanger is disposed in the heat dissipation cavity, so that heat dissipation efficiency can be improved and heat dissipation can be accelerated.

In an optional implementation, the first substrate extends in the vertical direction and protrudes from the first heat dissipation portion, and the first heat exchanger crosses the first substrate and overlaps the part that is of the first substrate and that protrudes from the first heat dissipation portion.

To enable the first power component to be at least partially located below the first heat dissipation portion, the first substrate extends downward and encloses a space with the first heat dissipation portion. The first heat exchanger is mounted in the space. That is, the first heat exchanger is mounted below the first heat dissipation portion and overlaps the part that is of the first substrate and that protrudes from the first heat dissipation portion. In this way, the heat sink and the first heat exchanger can be mounted more compactly, to reduce space occupied by the heat dissipation cavity.

In an optional implementation, the first heat exchanger is located in the heat dissipation cavity. The first heat exchanger includes a heat conducting plate and a heat dissipation fin that are connected to each other. The heat conducting plate is thermally attached to the first substrate. A first fan is disposed in the heat dissipation cavity. The first fan is configured to generate airflow to pass through the heat dissipation fin.

When a temperature of the electronic component increases, the temperature in the power cavity increases. The heat in the power cavity is transferred to the heat conducting plate through the first substrate. Then, the heat conducting plate transfers the heat to the heat dissipation fin. The first fan blows air toward the heat dissipation fin, and the heat dissipation cavity is open and ventilated, so that the heat on the heat dissipation fin can be blown out of the heat dissipation cavity through air, that is, blown to the outside. The first fan continuously rotates to continuously dissipate the heat on the heat dissipation fin, that is, implement indirect heat dissipation on the electronic component in the power cavity.

In an optional implementation, the first substrate extends in the vertical direction and protrudes from the first heat dissipation portion, the heat conducting plate is thermally attached to the part that is of the first substrate and that protrudes from the first heat dissipation portion, and the heat dissipation fin is located below the first heat dissipation portion.

The first substrate extends downward and encloses a space with the first heat dissipation portion. The first heat exchanger is mounted in the space, so that the heat sink and the first heat exchanger can be mounted more compactly, to reduce space occupied by the heat dissipation cavity. In addition, the first power component is in contact with the protruding part of the first substrate. The heat conducting plate is also in contact with the protruding part of the first substrate. In this way, heat can be better dissipated for the first power component in cooperation with the heat dissipation fin.

In an optional implementation, the separator is provided with a through opening. The first heat exchanger includes a heat conducting plate and a plurality of heat dissipation fins. The plurality of heat dissipation fins include a first heat dissipation fin and a second heat dissipation fin. The heat conducting plate is disposed at the through opening. The first heat dissipation fin and the second heat dissipation fin are fastened to different surfaces of the heat conducting plate. The heat conducting plate and the first heat dissipation fin are located in the heat dissipation cavity, and the second heat dissipation fin extends into the power cavity through the through opening; or the heat conducting plate and the second heat dissipation fin are located in the power cavity, and the first heat dissipation fin extends into the heat dissipation cavity through the through opening. A second fan is disposed in the power cavity, and is configured to generate airflow to pass through the second heat dissipation fin.

When a temperature of the electronic component increases, the temperature in the power cavity increases. The second fan blows air toward the second heat dissipation fin, so that the heat in the power cavity can be conducted to the second heat dissipation fin. The heat in the power cavity is transferred to the heat conducting plate through the second heat dissipation fin, and the heat conducting plate transfers the heat to the first heat dissipation fin. The heat dissipation cavity is open and ventilated, so that the first heat dissipation fin can exchange heat with the outside, to continuously dissipate heat on the first heat dissipation fin, that is, dissipate the heat in the power cavity.

In an optional implementation, the power cavity and the heat dissipation cavity are distributed in a first direction. The first direction is perpendicular to a vertical direction. The heat sink further includes a second substrate and a second heat dissipation portion. The second substrate and the first substrate are distributed in the vertical direction and fastened together. The second heat dissipation portion extends outward from the second substrate. A third gas-liquid channel is disposed in the second substrate. A fourth gas-liquid channel communicating with the third gas-liquid channel is disposed in the second heat dissipation portion. The third gas-liquid channel is isolated from the first gas-liquid channel. A second power component is disposed on the side that is of the circuit board and that faces the opening. The second power component is in contact with the second substrate in the heat dissipation cavity. A cooling medium used for gas-liquid conversion is disposed in the third gas-liquid channel.

When there is a height difference between the first power component and the second power component, the second substrate and the second heat dissipation portion can better dissipate heat for the second power component, to reduce a possibility that normal operating of the power conversion device is affected because the second power component heats up severely. In addition, the power cavity and the heat dissipation cavity are distributed in the first direction, and the first substrate and the second substrate are distributed in the vertical direction. This can reduce a dimension of the heat sink in the first direction, that is, reduce a dimension of the heat dissipation cavity in the first direction, to reduce a dimension of the power conversion device in the first direction.

In an optional implementation, the power conversion device further includes a second heat exchanger. The second heat exchanger is configured to transfer the heat in the power cavity to the heat dissipation cavity. Both the first heat exchanger and the second heat exchanger are disposed in the heat dissipation cavity. The first heat dissipation portion and the second heat dissipation portion are distributed in the vertical direction. The first substrate protrudes downward from the first heat dissipation portion. The second substrate protrudes downward from the second heat dissipation portion. One of the first heat exchanger and the second heat exchanger is located between the first heat dissipation portion and the second heat dissipation portion, and the other is located below the lower one of the first heat dissipation portion and the second heat dissipation portion.

The hot air in the power cavity may exchange heat with the air in the heat dissipation cavity through the first heat exchanger and the second heat exchanger, so that the temperature in the power cavity can be further reduced, and the power conversion device can operate stably. Because the first substrate protrudes downward from the first heat dissipation portion, and the second substrate protrudes downward from the second heat dissipation portion, there is spare space below both the first heat dissipation portion and the second heat dissipation portion. When the first heat exchanger and the second heat exchanger are disposed, the spare space can be fully utilized, so that the heat sink, the first heat exchanger, and the second heat exchanger are mounted more compactly, and space in the heat dissipation cavity is fully utilized, to reduce a dimension of the power component in the first direction.

In an optional implementation, a first heat exchange channel is formed in the first heat exchanger. A second heat exchange channel is formed in the second heat exchanger. Both an inlet of the first heat exchange channel and an inlet of the second heat exchange channel communicate with a first connecting pipe. Both an outlet of the first heat exchange channel and an outlet of the heat exchange channel communicate with a second connecting pipe. Both the first connecting pipe and the second connecting pipe are located in the heat dissipation cavity and communicate with the power cavity.

The hot air in the power cavity enters the first heat exchanger and the second heat exchanger through the first connecting pipe. The hot air in the first heat exchanger and the second heat exchanger exchanges heat with the air in the heat dissipation cavity, then enters the second connecting pipe, and returns to the power cavity through the second connecting pipe. The first heat exchanger communicates with and is fastened to the second heat exchanger through the first connecting pipe and the second connecting pipe, to improve a degree of integration of the first heat exchanger and the second heat exchanger. The first heat exchanger and the second heat exchanger do not need to separately communicate with the power cavity, to facilitate unified assembly and disassembly of the first heat exchanger and the second heat exchanger in the heat dissipation cavity.

In an optional implementation, both the first heat exchange channel and the second heat exchange channel extend in a second direction. The first connecting pipe and the second connecting pipe are located on different sides of the lower one of the first heat dissipation portion and the second heat dissipation portion in the second direction. The first direction, the second direction, and the vertical direction are perpendicular to each other.

The first heat dissipation portion, the first heat exchanger, the second heat dissipation portion, and the second heat exchanger are alternately distributed. Space above and below the lower one of the first heat dissipation portion and the second heat dissipation portion is respectively utilized by the first heat exchanger and the second heat exchanger. Space on two sides of the lower one of the first heat dissipation portion and the second heat dissipation portion is respectively utilized by the first connecting pipe and the second connecting pipe. In the foregoing layout manner, space of the heat dissipation cavity can be more fully utilized, to help reduce a volume of the power component.

In an optional implementation, the power conversion device further includes a protective cover. The heat dissipation cavity is formed inside the protective cover. The protective cover is provided with a heat dissipation hole. The heat dissipation hole includes an air inlet hole and an air outlet hole. One of the air inlet hole and the air outlet hole is located below the heat sink, and the other is located above the heat sink. A first fan is disposed in the heat dissipation cavity. The first fan is configured to drive air that enters through the air inlet hole to be discharged from the air outlet hole.

Under the effect of the first fan, air outside the protective cover may enter through the air inlet hole and be discharged through the air outlet hole. The air inlet hole and the air outlet hole are respectively located on upper and lower sides of the heat sink, so that the external air can fully pass through the heat sink, to improve the heat dissipation effect of the heat sink.

In an optional implementation, the first heat dissipation portion includes a plurality of first condensation pipes arranged at intervals. The second heat dissipation portion includes a plurality of second condensation pipes arranged at intervals. A plurality of fins are disposed between two adjacent ones of the first condensation pipes and between two adjacent ones of the second condensation pipes. In the first heat dissipation portion and the second heat dissipation portion, a quantity of fins disposed on the one close to the air inlet hole is less than a quantity of fins disposed on the one away from the air inlet hole.

Air closer to the air inlet hole has a lower temperature. When the air passes through the one close to the air inlet hole in the first heat dissipation portion and the second heat dissipation portion, heat exchange is performed. A temperature of the air after the heat exchange increases. In other words, in the heat dissipation cavity, air closer to the air outlet hole has a higher temperature. In the first heat dissipation portion and the second heat dissipation portion, sparse fins are arranged on the one close to the air inlet hole, so that a large amount of air passes. Dense fins are arranged on the one away from the air inlet hole, to enhance a heat dissipation capability. In this way, the first heat dissipation portion and the second heat dissipation portion that are vertically arranged can evenly dissipate heat.

In an optional implementation, in the first heat dissipation portion and the second heat dissipation portion, a dimension of the one close to the air inlet hole in the first direction is less than a dimension of the one away from the air inlet hole in the first direction.

In an arrangement manner with different lengths, more cold air can be blown to the one away from the air inlet hole in the first heat dissipation portion and the second heat dissipation portion, to enhance an overall heat dissipation capability of the heat sink and enable the first heat dissipation portion and the second heat dissipation portion to evenly dissipate heat.

In an optional implementation, the included angle between the first gas-liquid channel and the second gas-liquid channel is greater than 90 degrees and less than or equal to 160 degrees.

In the foregoing design manner, when the first gas-liquid channel is arranged in the vertical direction, the second gas-liquid channel is disposed obliquely upward from the first gas-liquid channel, so that liquid in the first heat dissipation portion flows back to the first substrate, to reduce a possibility that the liquid cooling medium is retained in the first heat dissipation portion.

In an optional implementation, the first power component is fastened to the first substrate through a bolt. The circuit board is provided with a through hole. The through hole is used for a head portion of the bolt to pass through. A rod portion of the bolt passes through the first power component and is threaded to the first substrate. The head portion of the bolt abuts against a surface that is of the first power component and that is away from the first substrate.

The first power component is fastened to the first substrate, so that the first power component can be in sufficient contact with the first substrate, to reduce a possibility of a gap between contact surfaces of the first power component and the first substrate. The first power component is closely attached to the first substrate, to achieve better heat dissipation effect for the first power component. In addition, the head portion of the bolt abuts against the first power component rather than the circuit board. This can reduce a possibility of damage to the circuit board during mounting and fastening through the bolt, and impact exerted on the circuit board when the first power component is connected to the first substrate.

In an optional implementation, a part of the first substrate faces a surface of the separator. The first substrate shields at least a part of the opening.

The heat dissipation cavity communicates with the outside through the heat dissipation hole. External impurities may enter the heat dissipation cavity. If the impurities in the heat dissipation cavity enter the power cavity, normal operating of the circuit board and a component (for example, the electronic component) on the circuit board is affected. A part of the first substrate faces a surface of the separator, so that the first substrate and the separator partially overlap. In this way, the first substrate can shield at least a part of the opening. This reduces a possibility that the air in the heat dissipation cavity enters the power cavity through the opening, to reduce a possibility that external impurities affect operating of the circuit board and a component on the circuit board, so that the power cavity and the heat dissipation cavity are more independent of each other. A cavity (namely, the power cavity) with a high protection rating is formed in the power conversion device to accommodate the circuit board. This is conducive to normal operating of the power conversion device.

In an optional implementation, an inner wall surface that is of the first substrate and that encloses the first gas-liquid channel includes a first wall surface and a second wall surface. The first wall surface and the second wall surface are disposed opposite to each other in a thickness direction of the first substrate. A plurality of support members are disposed between the first wall surface and the second wall surface. Each of the support members has one end connected to or abutting against the first wall surface and the other end connected to or abutting against the second wall surface.

The first substrate is hollow. The support members between the first wall surface and the second wall surface play a role in supporting the first wall surface and the second wall surface. That is, an internal cavity of the first substrate is supported through the support members, to reduce a possibility that the first substrate is crushed or bent, make a service life of the first substrate longer, and reduce a possibility that the heat sink fails due to local deformation.

In an optional implementation, the first substrate includes a bottom plate and a cover plate that are arranged in the first direction. The bottom plate is connected to the first power component. The cover plate is located on a side that is of the bottom plate and that is away from the first power component. An edge of the cover plate is fastened to an edge of the bottom plate. The cover plate bulges toward a side away from the bottom plate. The first gas-liquid channel is located between the cover plate and the bottom plate. Each of the support members has one end integrally connected to the bottom plate and the other end connected to or abutting against the cover plate. The plurality of support members are divided into a plurality of rows of support groups arranged in the vertical direction. The support group in each row includes a plurality of support members arranged in the second direction. The first direction, the second direction, and the vertical direction are perpendicular to each other. A flow equalization channel extending in the second direction is formed between the support groups in two adjacent rows. The flow equalization channel communicates with the second gas-liquid channel. Surfaces that are of the plurality of support members in the support group in each row and that face upward in the vertical direction are flush. Surfaces that are of the plurality of support members in the support group in each row and that face downward in the vertical direction are flush. For each of the support members, the surface facing upward in the vertical direction is parallel to the surface facing downward in the vertical direction.

The foregoing design manner facilitates extrusion molding of the bottom plate and the plurality of support groups thereon. For example, the bottom plate and the plurality of support groups thereon are produced through extrusion, and then each support group is divided into the plurality of support members through turning processing (or in another processing manner). This helps improve production and processing efficiency of the first substrate.

In an optional implementation, the heat sink further includes a confluence portion. The confluence portion is disposed in the heat dissipation cavity and connected to an end that is of the first heat dissipation portion and that is away from the first substrate. The second gas-liquid channel includes a plurality of subchannels. A confluence channel communicating with the different subchannels in the second gas-liquid channel is disposed in the confluence portion, so that the different subchannels in the second gas-liquid channel communicate with each other.

In some cases, the second gas-liquid channel has a plurality of different gas-liquid channels. The confluence portion is disposed in the heat sink, so that the different gas-liquid channels in the second gas-liquid channel can communicate with each other, and the cooling medium in the different gas-liquid channels can converge into the confluence portion. This helps the cooling medium condense and return.

In an optional implementation, the heat sink further includes a return pipe. The return pipe is disposed below the first heat dissipation portion. The return pipe has one end communicating with the first gas-liquid channel and the other end communicating with the confluence channel.

After heat dissipation and condensation in the first heat dissipation portion, the cooling medium gradually changes back to the liquid cooling medium. A part of the liquid cooling medium flows back to the first substrate from the first heat dissipation portion. The other part of the liquid cooling medium flows into the confluence channel of the confluence portion, enters the return pipe from the confluence portion, and then flows back to the first substrate through the return pipe. The first substrate, the first heat dissipation portion, the confluence portion, and the return pipe communicate with each other, to reduce the possibility that the liquid cooling medium is retained in the first heat dissipation portion.

In an optional implementation, the confluence portion includes a first plate and a second plate. An edge of the first plate is fastened to an edge of the second plate. The first plate is connected to the end that is of the first heat dissipation portion and that is away from the first substrate. The second plate is located on a side that is of the first plate and that is away from the first heat dissipation portion. The second plate bulges toward a side away from the first plate. The confluence channel is located between the first plate and the second plate. The second plate is provided with a plurality of concave structures. The plurality of concave structures are concave into the confluence channel in a direction close to the first plate. The plurality of concave structures abut against the first plate.

The concave structures of the second plate are concave into the confluence channel in the direction close to the first plate and abut against the first plate. The concave structures can support an internal cavity (the confluence channel) of the confluence portion, to reduce a possibility that the confluence channel collapses under pressure and improve structural strength of the confluence portion.

In an optional implementation, a first evaporation zone is disposed in the first gas-liquid channel. A side that is of the first evaporation zone and that faces the first power component is connected to the inner wall surface of the first substrate. An outer wall surface corresponding to the inner wall surface that is of the first substrate and that is connected to the first evaporation zone is in contact with the first power component. The first gas-liquid channel includes a first cavity and a second cavity that are located on two sides of the first evaporation zone in the vertical direction. A plurality of first flow channels communicating with the first cavity and the second cavity are disposed in the first evaporation zone.

The first power component abuts against a region in which the first evaporation zone is disposed on the first substrate. The heat of the first power component is transferred to the first evaporation zone through the first substrate. Because the plurality of first flow channels are disposed in the first evaporation zone, a contact area of the first evaporation zone and the cooling medium is larger, leading to more boiling nucleation points in the first evaporation zone. The cooling medium needs to flow between the first cavity and the second cavity through the first flow channels. That is, the cooling medium flows from a lower part of the first evaporation zone to an upper part of the first evaporation zone through the first flow channels. More boiling nucleation points help the liquid cooling medium become gaseous.

In an optional implementation, second evaporation zones are disposed on two sides of the first evaporation zone. A distribution direction of the two second evaporation zones is perpendicular to the vertical direction. A plurality of second flow channels communicating with the first cavity and the second cavity are disposed in the second evaporation zone. A quantity of the second flow channels in each of the second evaporation zones is less than a quantity of the first flow channels.

The two second evaporation zones are located on the two sides of the first power component. The plurality of second flow channels are disposed in the second evaporation zone, leading to more boiling nucleation points in the second evaporation zone. This helps the liquid cooling medium become gaseous when the cooling medium flows through the second flow channels. Because the second evaporation zones are away from the first power component, the first evaporation zone is close to the first power component, and the quantity of the second flow channels in each of the second evaporation zones is less than the quantity of the first flow channels, more cooling medium can pass through the first evaporation zone.

### BRIEF DESCRIPTION OF DRAWINGS

FIG. 1 is a diagram of an external structure of a power conversion device according to an embodiment of this application;
FIG. 2 is a diagram of an internal cavity of a power conversion device according to an embodiment of this application;
FIG. 3 is a diagram of an internal structure of a heat dissipation cavity of a first power conversion device according to an embodiment of this application;
FIG. 4 is a partial exploded view of a power conversion device according to an embodiment of this application;
FIG. 5 is a diagram of an internal structure of a heat sink according to an embodiment of this application;
FIG. 6 is an enlarged view of A in FIG. 4;
FIG. 7 is a diagram of another internal structure of a heat sink according to an embodiment of this application;
FIG. 8 is a diagram of a mounting manner of fins according to an embodiment of this application;
FIG. 9 is a diagram of a partial structure of fins according to an embodiment of this application;
FIG. 10 is a diagram of a structure of a confluence portion according to an embodiment of this application;
FIG. 11 is a diagram of a structure of a first plate and a second plate according to an embodiment of this application;
FIG. 12 is a diagram of another structure of a confluence portion according to an embodiment of this application;
FIG. 13 is a diagram of a structure of a return pipe according to an embodiment of this application;
FIG. 14 is a diagram of a structure of a first evaporation zone according to an embodiment of this application;
FIG. 15 is a diagram of another structure of a first evaporation zone according to an embodiment of this application;
FIG. 16 is a diagram of a structure of a support group according to an embodiment of this application;
FIG. 17 is a diagram of a structure of a cover plate and a bottom plate according to an embodiment of this application;
FIG. 18 is a diagram of a structure of a threaded hole according to an embodiment of this application;
FIG. 19 is a diagram of another structure of a threaded hole according to an embodiment of this application;
FIG. 20 is a diagram of still another structure of a threaded hole according to an embodiment of this application;
FIG. 21 is a diagram of an internal structure of a heat dissipation cavity of a second power conversion device according to an embodiment of this application;
FIG. 22 is a diagram of an internal structure of a heat dissipation cavity of a third power conversion device according to an embodiment of this application;
FIG. 23 is a diagram of an internal structure of a heat dissipation cavity of a fourth power conversion device according to an embodiment of this application;
FIG. 24 is a partial exploded view of a fourth power conversion device according to an embodiment of this application;
FIG. 25 is a diagram of a structure of another heat sink according to an embodiment of this application;
FIG. 26 is a diagram of a structure of still another heat sink according to an embodiment of this application;
FIG. 27 is a diagram of a structure of a first connecting pipe and a second connecting pipe according to an embodiment of this application;
FIG. 28 is a diagram of an internal structure of a heat dissipation cavity of a fifth power conversion device according to an embodiment of this application;
FIG. 29 is a partial exploded view of a fifth power conversion device according to an embodiment of this application;
FIG. 30 is a diagram of an internal structure of a heat dissipation cavity of a sixth power conversion device according to an embodiment of this application; and
FIG. 31 is a diagram of various positions of a first heat exchanger according to an embodiment of this application.

### Reference numerals:

100-power conversion device;
1-housing; 11-separator; 111-power cavity; 112-heat dissipation cavity; 113-opening; 114-mounting opening; 115-through opening; 12-protective cover; 121-heat dissipation hole; 1211-air inlet hole; 1212-air outlet hole;
2-circuit board; 21-first power component; 211-bolt; 2111-head portion; 2112-rod portion; 22-through hole; 23-second power component; 24-inductor; 25-electronic component;
3-heat sink; 31-first substrate; 310-first gas-liquid channel; 311-first wall surface; 312-second wall surface; 313-support member; 3131-support group; 3132-flow equalization channel; 314-first evaporation zone; 3141-first flow channel; 3142-rib; 315-second evaporation zone; 3151-second flow channel; 316-first cavity; 317-second cavity; 318-bottom plate; 3181-threaded hole; 319-cover plate; 3191-boss; 32-first heat dissipation portion; 320-second gas-liquid channel; 321-first condensation pipe; 3211-subchannel; 33-accommodating space; 34-fin; 341-bent section; 342-ventilation channel; 35-confluence portion; 350-confluence channel; 3501-first plate; 351-second plate; 3511-concave structure; 352-confluence pipe; 353-return pipe; 36-second substrate; 360-third gas-liquid channel; 37-second heat dissipation portion; 370-fourth gas-liquid channel; 371-second condensation pipe;
4-first heat exchanger; 41-first flat heat dissipation pipe; 42-first heat dissipation sheet; 43-heat conducting plate; 44-heat dissipation fin; 441-first heat dissipation fin; 442-second heat dissipation fin;
5-second heat exchanger; 51-first flat heat dissipation pipe; 22-first heat dissipation sheet;
6-first connecting pipe; 61-heat exchange inlet; 7-second connecting pipe; 71-heat exchange outlet; 8-first fan; 9-second fan.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

In this application, unless otherwise expressly specified and limited, orientations or position relationships indicated by terms such as "above" and "below" may include but are not limited to those defined relative to schematic orientations of components in the accompanying drawings. These directional terms may be relative concepts used for relative description and clarification and correspondingly change based on changes in the orientations of the components in the accompanying drawings, and cannot be understood as a limitation on this application.

In this application, the terms "first", "second", and the like are merely intended for a purpose of description, and are intended to distinguish between one element and another element, but cannot be understood as an indication or implication of relative importance or an implicit indication of a quantity of indicated technical features. Therefore, a feature limited by "first", "second", or the like may explicitly or implicitly include one or more features.

In this application, unless otherwise expressly specified and limited, "a plurality of" means two or more.

In this application, unless otherwise expressly specified and limited, terms "mount", "interconnect", and "connect" should be understood in a broad sense. For example, such terms may indicate a fixed connection, a detachable connection, or an integral connection; may indicate a mechanical connection or an electrical connection; or may indicate a direct interconnection, an indirect interconnection through an intermediate medium, or an internal communication between two elements. For a person of ordinary skill in the art, a specific meaning of the foregoing terms in this application may be understood based on a specific situation. In addition, when a pipeline or a channel is described, "interconnect" and "connect" used in this application have a meaning of conduction. A specific meaning needs to be understood based on the context.

In addition, in this application, the term "example", "for example", or the like indicates giving an example, an illustration, or a description. Any embodiment or design scheme described as an "example" or "for example" in this application should not be construed as being more preferred or having more advantages than another embodiment or design scheme. Exactly, use of the term "example", "for example", or the like is intended to present a relative concept in a specific manner.

In the accompanying drawings of embodiments of this application, entity structures such as components and assemblies are represented by using guide lines, and hollow-out structures such as openings, holes, space, and cavities are represented by using guide lines with arrows.

Embodiments of this application provide a power conversion device 100. For example, the power conversion device 100 includes a photovoltaic inverter, especially a string photovoltaic inverter with a high power level of 400 kW or above. When a unit power of the photovoltaic inverter reaches 400 kW or above, a conventional heat dissipation solution in a form of a physical structure cannot meet a heat dissipation requirement of a power component with such a high power, and a new heat dissipation solution with a stronger capability needs to be found to meet a new challenge. For example, in embodiments of this application, a two-phase heat dissipation technology is introduced into the photovoltaic inverter. Heat of a power component in an ultra-high-power photovoltaic inverter is effectively dissipated in time through gas-liquid conversion of a heat conducting medium inside and outside a power cavity, to ensure long-term stable operation of the power conversion device 100.

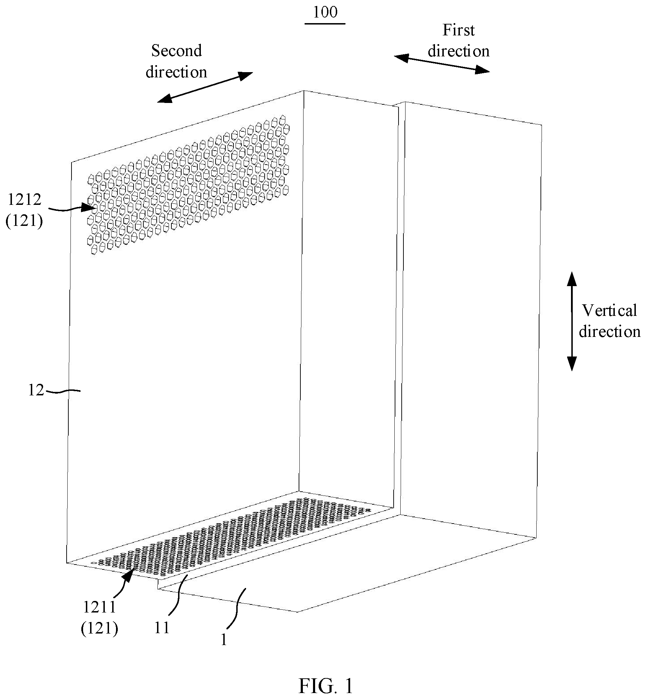

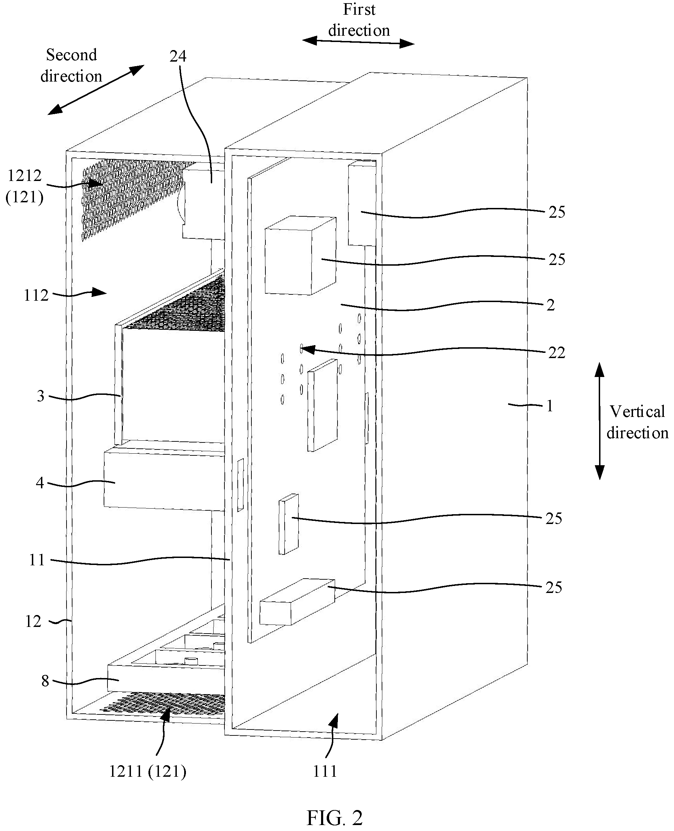

FIG. 1 shows an example of an external structure of the power conversion device 100. FIG. 2 shows an example of an internal cavity of the power conversion device 100. As shown in FIG. 1 and FIG. 2, when the power conversion device 100 is a photovoltaic inverter, it is vertically mounted. In a vertical direction, various input interfaces are mounted at the bottom of the power conversion device 100, including a large quantity of photovoltaic input terminals, communication ports, and the like.

With reference to FIG. 1 and FIG. 2, the power conversion device 100 includes a housing 1. The housing 1 includes a cabinet structure (for example, a cabinet), a box structure (for example, a chassis), or the like. A shape of the housing 1 is not specifically limited in this application. The housing 1 includes a separator 11. For example, the separator 11 includes a side wall (or referred to as a side plate or a housing plate) of the housing 1. In other words, the separator 11 is a part of the housing 1. A sealed power cavity 111 is formed inside the housing 1. An open and ventilated heat dissipation cavity 112 is formed outside the housing 1. The separator 11 is located between the power cavity 111 and the heat dissipation cavity 112. In other words, the power cavity 111 is an internal cavity of the housing 1, and the heat dissipation cavity 112 is located outside the housing 1.

The heat dissipation cavity 112 may be formed by disposing a protective cover 12 outside the housing 1. For example, with reference to FIG. 1 and FIG. 2, the power conversion device 100 further includes the protective cover 12. The heat dissipation cavity 112 is formed inside the protective cover 12. The power cavity 111 and the heat dissipation cavity 112 are distributed in a first direction. The first direction is perpendicular to the vertical direction. The protective cover 12 is provided with a heat dissipation hole 121 communicating with the internal heat dissipation cavity 112. In some examples, the protective cover 12 has a hollow-out structure, and the heat dissipation hole 121 includes a hole in the protective cover 12 that is hollowed out. In the examples shown in FIG. 1 and FIG. 2, the heat dissipation hole 121 is provided in a partial region of the protective cover 12. In another example, the heat dissipation hole 121 may be provided in an entire region of each wall of the protective cover 12. This is not specifically limited in this application.

With reference to FIG. 2, the power conversion device 100 further includes a circuit board 2, for example, a printed circuit board (Printed Circuit Board, PCB). The circuit board 2 is disposed in the power cavity 111. The circuit board 2 may be disposed in parallel with the separator 11. A plurality of components are disposed on the circuit board 2. To protect the circuit board 2 and the components on the circuit board 2, a protection rating of the power cavity 111 is higher than that of the heat dissipation cavity 112. For example, an IP (Ingress Protection) rating of the power cavity 111 is higher than that of the heat dissipation cavity 112.

The components disposed on the circuit board 2 include at least one of a chip, a resistor, a capacitor, a diode, or a triode. The plurality of components may be disposed on a same side surface of the circuit board 2. Alternatively, at least one of the plurality of components may be disposed on a side surface that is of the circuit board 2 and that is away from the separator 11, and the other components may be disposed on a side surface that is of the circuit board 2 and that is close to the separator 11. For example, a plurality of electronic components 25 (including but not limited to a capacitor, an inductor, a relay, and the like) are disposed on the side surface that is of the circuit board 2 and that is away from the separator 11.

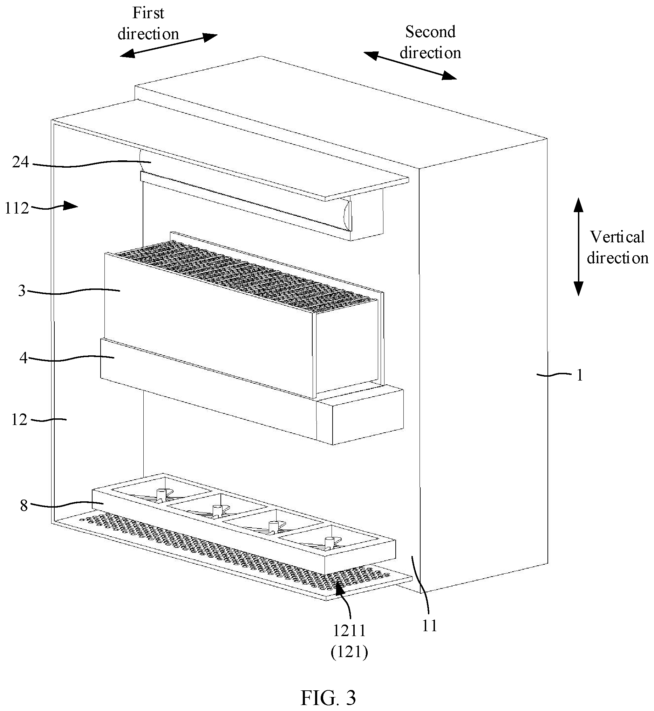

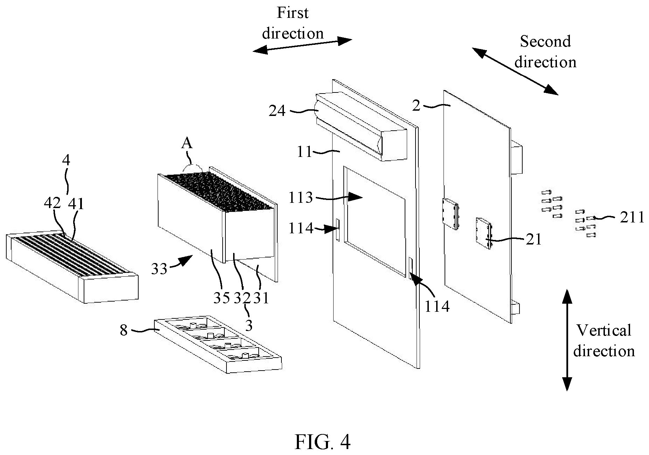

In this application, an example in which the plurality of components are disposed on both side surfaces of the circuit board 2 is used. FIG. 3 shows an example of an internal structure of the power conversion device 100. FIG. 4 shows an example of an exploded view of a partial structure of the power conversion device 100. With reference to FIG. 3 and FIG. 4, the separator 11 is provided with an opening 113. The opening 113 communicates with the power cavity 111 and the heat dissipation cavity 112. The opening 113 includes a square opening or a circular opening.

A first power component 21 is disposed on a side that is of the circuit board 2 and that faces the opening 113. The first power component 21 forms a power conversion circuit of the power conversion device 100, to perform power conversion on a direct current input to the power conversion device 100. For example, the first power component 21 includes a power module or a plurality of groups of power switching transistors. In some examples, the first power component 21 may be a component that heats up severely on the circuit board 2. An end that is of the first power component 21 and that is connected to the circuit board 2 is located in the power cavity 111. An end that is of the first power component 21 and that is away from the circuit board 2 extends toward the heat dissipation cavity 112. The first power component 21 and the others of the plurality of components on the circuit board 2 are mounted on two opposite side surfaces of the circuit board 2 and separated by the circuit board 2, to avoid transferring heat of the first power component 21 to the power cavity 111 on the other side of the circuit board 2, which increases a temperature in the power cavity 111 and causes thermal pollution to another component that also needs to be protected.

It can be learned that in embodiments of this application, a heat dissipation solution of the power conversion device 100 is based on graded and classified heat dissipation. Specifically, different heat dissipation manners and heat conduction paths are designed for the first power component 21 with high heat, the electronic components 25 with low heat and a need for high protection, and an inductive component with high heat to dissipate heat. A core of the heat dissipation solution is two-phase enhanced heat dissipation, to dissipate heat for and protect a core component and a core heat source. For example, high-intensity internal and external two-phase-change heat dissipation is performed on the first power component 21, to ensure that heat of the entire device is well resolved, and various electronic components are also protected at different ratings based on their characteristics.

With reference to FIG. 3 and FIG. 4, the power conversion device 100 further includes a heat sink 3. The heat sink 3 is disposed in the heat dissipation cavity 112. The heat sink 3 includes a first substrate 31 and a first heat dissipation portion 32 whose internal cavities communicate with each other. The first substrate 31 extends in the vertical direction and protrudes from the first heat dissipation portion 32. For example, the first substrate 31 protrudes downward from the first heat dissipation portion 32. The first substrate 31 is disposed at the opening 113. The first power component 21 is located in the power cavity 111 and is in thermal contact with the first substrate 31. The first heat dissipation portion 32 is disposed on a side that is of the first substrate 31 and that is away from the separator 11.

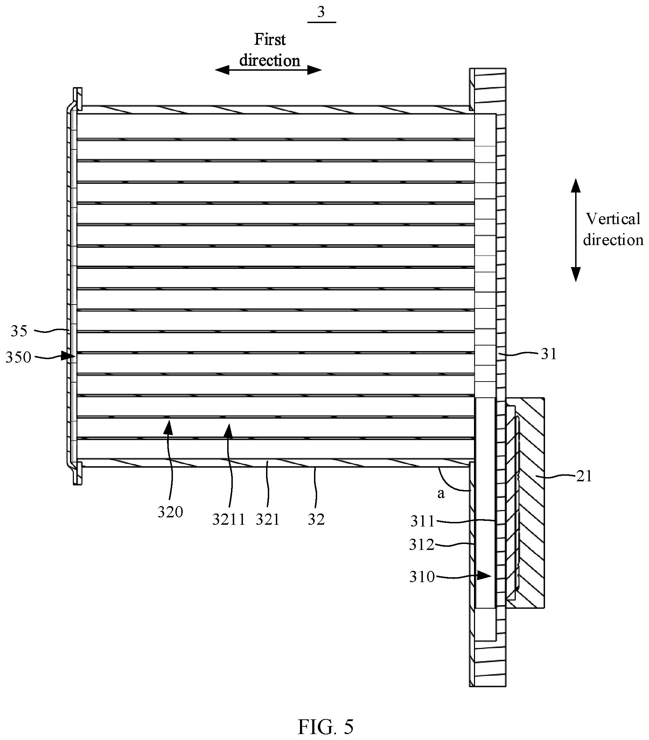

FIG. 5 shows an example of an internal structure of the heat sink 3. A first gas-liquid channel 310 is disposed in the first substrate 31. A second gas-liquid channel 320 communicating with the first gas-liquid channel 310 is disposed in the first heat dissipation portion 32. A cooling medium used for gas-liquid conversion is disposed in the internal cavity of the first substrate 31. The cooling medium includes water or another refrigerant that can perform gas-liquid conversion.

When the first power component 21 generates heat, the heat of the first power component 21 is transferred to the first substrate 31, and the cooling medium in the first substrate 31 is heated. After the liquid cooling medium is heated up, at least a part of the cooling medium becomes gaseous. The gaseous cooling medium flows into the first heat dissipation portion 32, that is, enters the second gas-liquid channel 320 from the first gas-liquid channel 310. The heat dissipation hole 121 (with auxiliary reference to FIG. 2), in the housing 1, communicating with the heat dissipation cavity 112 facilitates heat exchange between the cooling medium in the first heat dissipation portion 32 and the outside, so that the gaseous cooling medium undergoes heat dissipation and condenses in the first heat dissipation portion 32, gradually returns to the liquid state, and then flows back from the second gas-liquid channel 320 to the first gas-liquid channel 310 of the first substrate 31. In this way, heat is continuously dissipated for the first power component 21. Targeted heat dissipation is performed on the first power component 21, so that the power conversion device 100 can operate stably.

To effectively dissipate heat, the heat dissipation cavity 112 communicates with the outside through the heat dissipation hole 121. The separator 11 can reduce a possibility that impurities from the heat dissipation cavity 112 or the outside enter the power cavity 111. In addition, the first substrate 31 is disposed at the opening 113, so that the first substrate 31 can be in contact with the first power component 21, and shield the opening 113 to further reduce a possibility of mutual interference between the heat dissipation cavity 112 and the power cavity 111. In this way, the circuit board 2 can be disposed in the power cavity 111 with a relatively strong protection capability, to ensure safety of other components (such as the plurality of electronic components 25) and reduce a possibility of a fault in the power conversion device 100 while dissipating the heat of the first power component 21.

With reference to FIG. 3 and FIG. 4, in an example, an edge part of the first substrate 31 faces a surface of the separator 11. The first substrate 31 shields the opening 113. It should be noted that, that a part of a surface of the first substrate 31 faces a surface of the separator 11 means that the first substrate 31 and the separator 11 overlap in the first direction. In the case of overlapping, the first substrate 31 may abut against the separator 11. Even if there is no abutment, the opening 113 can be better shielded when the first substrate 31 and the separator 11 overlap. This reduces a possibility that air in the heat dissipation cavity 112 enters the power cavity 111 through the opening 113, to reduce a possibility that external impurities affect operating of the circuit board 2 and the components on the circuit board 2, so that the power cavity 111 and the heat dissipation cavity 112 are more independent of each other. A cavity (the power cavity 111) with a high protection rating is formed in the power conversion device 100 to accommodate the circuit board 2. This is conducive to normal operating of the power conversion device 100.

For better heat dissipation, the first power component 21 is at least partially located below the first heat dissipation portion 32. In the example shown in FIG. 5, a part of the first power component 21 extends below the first heat dissipation portion 32 and is in thermal contact with a part that is of the first substrate 31 and that protrudes below the first heat dissipation portion 32. The other part of the first power component 21 faces the first heat dissipation portion 32 in the first direction. In this way, the first heat dissipation portion 32 and the first power component 21 have a small overlapping region in the first direction, so that the first heat dissipation portion 32 has a larger region for heat exchange with air in the heat dissipation cavity 112. This helps improve heat dissipation effect of the heat sink 3.

In another example, the first power component 21 is completely located below the first heat dissipation portion 32, and is in thermal contact with the part that is of the first substrate 31 and that protrudes below the first heat dissipation portion 32. That is, the first power component 21 and the first heat dissipation portion 32 are located on two sides of the first substrate 31, and there is a spacing between the first power component 21 and the first heat dissipation portion 32 in the vertical direction. In other words, the first power component 21 and the first heat dissipation portion 32 do not overlap in the first direction.

For a structure of the first substrate 31, in an example provided in this application, with reference to FIG. 4 and FIG. 5, the first substrate 31 has a square plate-like structure. In another example, the first substrate 31 may alternatively be a disk-shaped plate or another special-shaped plate without an obvious shape. This is not limited in this application.

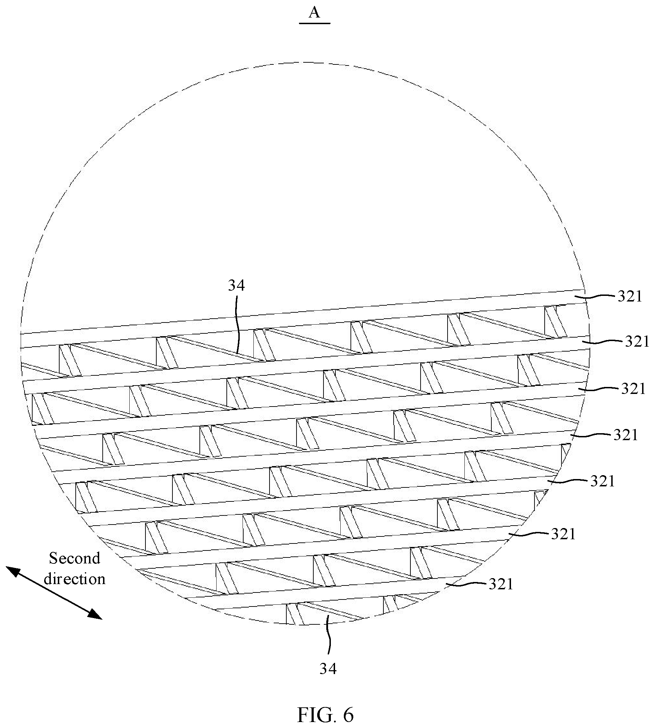

The first heat dissipation portion 32 has a structure that can perform condensation. For example, the first heat dissipation portion 32 is a microchannel condenser provided with a heat dissipation sheet. FIG. 6 is an enlarged view of A in FIG. 4. With reference to FIG. 5 and FIG. 6, the first heat dissipation portion 32 includes a plurality of first condensation pipes 321 arranged at intervals in a second direction. The first direction, the second direction, and the vertical direction are perpendicular to each other. In the example shown in FIG. 5, each first condensation pipe 321 may be a microchannel flat pipe. A plurality of subchannels 3211 (namely, microchannels in the microchannel flat pipe) in each first condensation pipe 321 are arranged in the vertical direction. Each subchannel 3211 extends in the first direction.

It should be noted that the subchannel 3211 is a channel in which the cooling medium can flow. Dimensions and a structure of the subchannel 3211 are not limited in this application. The plurality of subchannels 3211 in each first condensation pipe 321 form an internal cavity of the first condensation pipe 321. The internal cavities of the plurality of first condensation pipes 321 form the second gas-liquid channel 320 of the first heat dissipation portion 32. In another example, the first condensation pipe 321 may not be a plate-shaped pipe with a plurality of layers of channels disposed inside, but a plate-like pipe with a complete cavity inside, or a serpentine pipe. This is not limited in this application.

In an example, with reference to FIG. 6, a plurality of fins 34 are disposed between two adjacent first condensation pipes 321. In another example, the fins 34 may not be disposed.

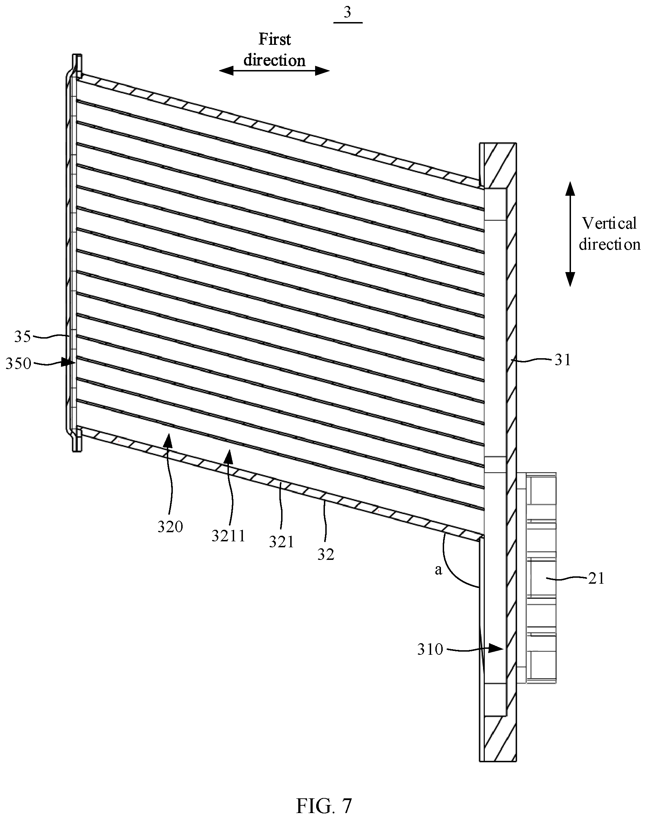

After changing to the liquid state, the cooling medium in the first heat dissipation portion 32 needs to return to the first substrate 31. To help the cooling medium in the first heat dissipation portion 32 return to the first substrate 31, in some examples, with reference to FIG. 7, the first heat dissipation portion 32 may be obliquely disposed. FIG. 7 shows an example of another structure of the first heat dissipation portion 32. For example, an included angle a between the first gas-liquid channel 310 and the second gas-liquid channel 320 is greater than 90 degrees and less than 180 degrees. The included angle a includes 95 degrees, 120 degrees, 150 degrees, 160 degrees, or 170 degrees. Alternatively, the included angle a falls within a range between these angles. For another example, the included angle a between the first gas-liquid channel 310 and the second gas-liquid channel 320 is greater than 90 degrees and less than or equal to 160 degrees. The included angle a includes 110 degrees, 130 degrees, 140 degrees, 160 degrees, or the like. Alternatively, the included angle a falls within a range between these angles. A specific angle is formed between the first gas-liquid channel 310 and the second gas-liquid channel 320, so that the cooling medium can smoothly return under gravity to a position that is in the first substrate 31 and that is close to the part in thermal contact with the first power component 21.

When the first heat dissipation portion 32 needs to be obliquely disposed, in an example in which the first heat dissipation portion 32 includes the plurality of first condensation pipes 321 (such as microchannel flat pipes), the first condensation pipes 321 are flat pipes with a parallelogram-like structure, and each subchannel 3211 is disposed obliquely upward from the first substrate 31 in the first direction, so that liquid in the first heat dissipation portion 32 returns to the first substrate 31. This reduces a possibility that the liquid cooling medium is retained in the first heat dissipation portion 32.

In the example shown in FIG. 5, the included angle a between the first gas-liquid channel 310 and the second gas-liquid channel 320 is alternatively 90 degrees. In other words, the first gas-liquid channel 310 and the second gas-liquid channel 320 are perpendicular to each other.

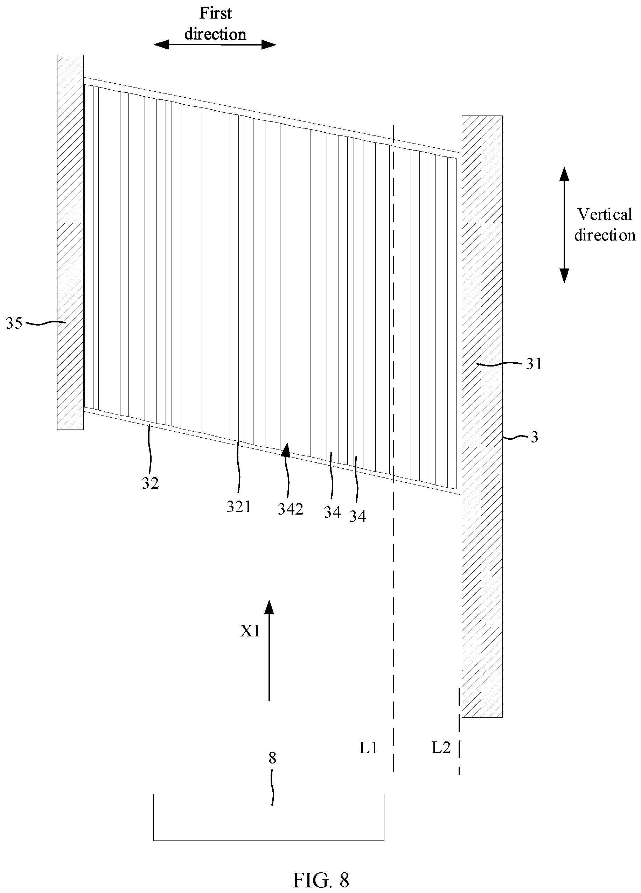

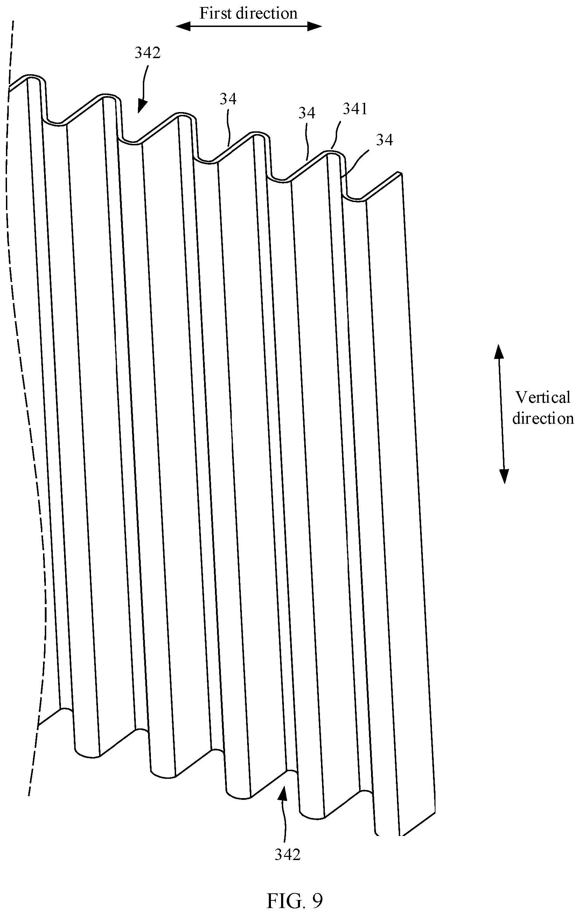

In some examples, when the plurality of fins 34 are disposed between the two adjacent first condensation pipes 321, a mounting manner of the fins 34 is adjusted, so that air can better dissipate heat for the fins 34. The mounting manner of the fins 34 is described by using an example in which the first heat dissipation portion 32 is oblique. FIG. 8 shows an example of the mounting manner of the fins 34. FIG. 9 shows a partial structure of the fins 34 in FIG. 8. With reference to FIG. 9, the plurality of fins 34 between the two adjacent first condensation pipes 321 are arranged in the first direction. In addition, two adjacent fins 34 are integrally connected through a bent section 341 between the two fins 34, so that the plurality of fins 34 between the two adjacent first condensation pipes 321 and a plurality of bent sections form a corrugated plate-shaped structure (alternatively, the two adjacent fins 34 may not be connected, such as a solution of the fins 34 in FIG. 6). There is a ventilation channel 342 between the two adjacent fins 34. The ventilation channel 342 is parallel to a ventilation direction. For example, with reference to FIG. 8, the power conversion device 100 further includes a first fan 8 (for a position of the first fan 8, auxiliary reference may be made to FIG. 3 and FIG. 4). The first fan 8 may be disposed below the ventilation channel 342. Under the effect of the first fan 8, air passes through the first heat dissipation portion 32 in the vertical direction (an arrow X1 indicates a flow direction of the air). In this case, the ventilation channel 342 extends in the vertical direction (a dashed line L1 is an extension direction of the ventilation channel 342). In other words, the extension direction of the ventilation channel 342 is parallel to a surface of the substrate 31 (the dashed line L1 is parallel to a dashed line L2). This design manner can reduce resistance of the air passing through the first heat dissipation portion 32 and a possibility that the ventilation channel 342 is clogged with dust, to improve the heat dissipation effect of the heat sink 3.

In addition, to help the cooling medium return, the heat sink 3 may further include a confluence portion 35. FIG. 5 and FIG. 7 respectively show positions of the confluence portion 35 in two examples. The confluence portion 35 is disposed on a side that is of the first heat dissipation portion 32 and that is away from the first substrate 31. A confluence channel 350 is disposed in the confluence portion 35. The confluence channel 350 of the confluence portion 35 communicates with the second gas-liquid channel 320 of the first heat dissipation portion 32. When the first heat dissipation portion 32 includes the plurality of first condensation pipes 321 and each first condensation pipe 321 includes the plurality of subchannels 3211 (with auxiliary reference to the foregoing description of this part), the confluence channel 350 communicates with different subchannels 3211 in the second gas-liquid channel 320, so that the different subchannels 3211 in the second gas-liquid channel 320 communicate with each other through the confluence channel 350. After heat dissipation and condensation in the first heat dissipation portion 32, the cooling medium gradually changes back to the liquid cooling medium. A part of the liquid cooling medium directly flows back to the first substrate 31 from the first heat dissipation portion 32 without entering the confluence portion 35. The other part of the liquid cooling medium flows into the confluence channel 350 of the confluence portion 35, flows downward through the confluence channel 350, and then flows back to the first substrate 31 through the bottom of the second gas-liquid channel 320. This helps the cooling medium condense and return.

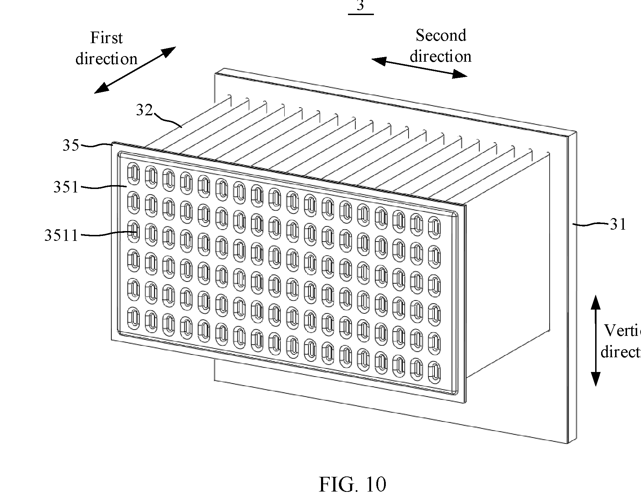

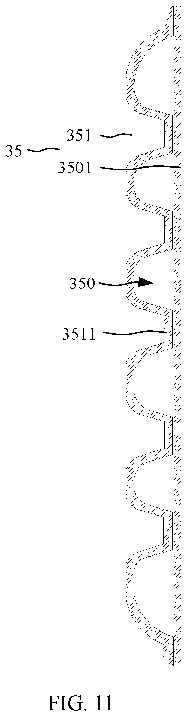

FIG. 10 shows an example of a structure of the confluence portion 35. The confluence portion 35 may include a first plate 3501 and a second plate 351. FIG. 11 shows an example of a structure of the first plate 3501 and the second plate 351. With reference to FIG. 10 and FIG. 11, an edge of the first plate 3501 is fastened (for example, welded) to an edge of the second plate 351. The first plate 3501 (blocked by the second plate 351 in FIG. 10 and located behind the second plate 351) is connected to the first heat dissipation portion 32. The second plate 351 is located on a side that is of the first plate 3501 and that is away from the first heat dissipation portion 32. The second plate 351 bulges toward a side away from the first plate 3501, so that the first plate 3501 and the second plate 351 enclose the confluence channel 350. In addition, the second plate 351 may be provided with a plurality of concave structures 3511. The concave structures 3511 are concave into the confluence channel 350 in a direction close to the first plate 3501 and abut against the first plate 3501, to play a supporting role and reduce a possibility that an internal cavity of the confluence portion 35 collapses under pressure.

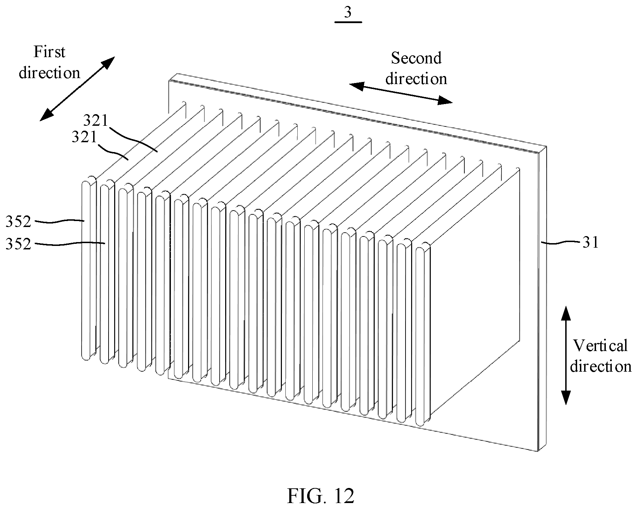

FIG. 12 shows an example of another structure of the confluence portion 35. In the example shown in FIG. 12, the first heat dissipation portion 32 includes a plurality of first condensation pipes 321. The confluence portion 35 includes a plurality of confluence pipes 352. Each confluence pipe 352 communicates with different subchannels 3211 in one first condensation pipe 321 (for a structure of the subchannel 3211, refer to FIG. 5 and FIG. 7). Internal space of all the confluence pipes 352 forms the confluence channel 350. In another example, each confluence pipe 352 is a solid pipe.

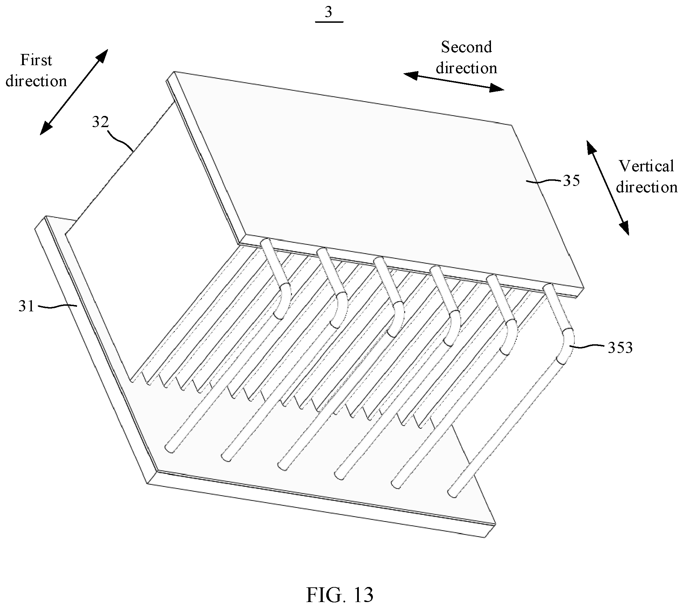

FIG. 13 shows an example of still another structure of the confluence portion 35. With reference to FIG. 13, the confluence portion 35 is constructed as a hollow plate or a hollow box-like structure. In this example, a support structure may alternatively be disposed in the confluence channel 350 of the confluence portion 35. A function of the support structure is the same as that of the concave structures 3511 in FIG. 10. A difference between the support structure and the concave structures 3511 in FIG. 10 lies in that the concave structures 3511 in FIG. 10 are directly formed on the second plate 351 by locally applying pressure or in another manner during processing, and the support structure in the example shown in FIG. 13 is disposed additionally (for example, through post-welding) to enhance support. The example shown in FIG. 13 is another example in which the support structure is not disposed.

In some examples, the heat sink 3 further includes a return pipe 353. For example, for the confluence portion 35 shown in FIG. 13, the return pipe 353 is disposed below the first heat dissipation portion 32. The return pipe 353 has one end communicating with the first gas-liquid channel 310 in the first substrate 31 and the other end communicating with the confluence channel 350 in the confluence portion 35. For positions of the first gas-liquid channel 310 and the confluence channel 350, refer to FIG. 5 or FIG. 7. A plurality of return pipes 353 may be disposed and distributed at intervals in the second direction.

In the foregoing example, after heat dissipation and condensation in the first heat dissipation portion 32, the cooling medium gradually changes back to the liquid cooling medium. A part of the liquid cooling medium flows back to the first substrate 31 from the second gas-liquid channel 320 of the first heat dissipation portion 32. The other part of the liquid cooling medium flows into the confluence portion 35, enters the return pipe 353 from the confluence channel 350, and then flows back to the first substrate 31 through the return pipe 353. The first substrate 31, the first heat dissipation portion 32, the confluence portion 35, and the return pipe 353 communicate with each other, to reduce the possibility that the liquid cooling medium is retained in the first heat dissipation portion 32.

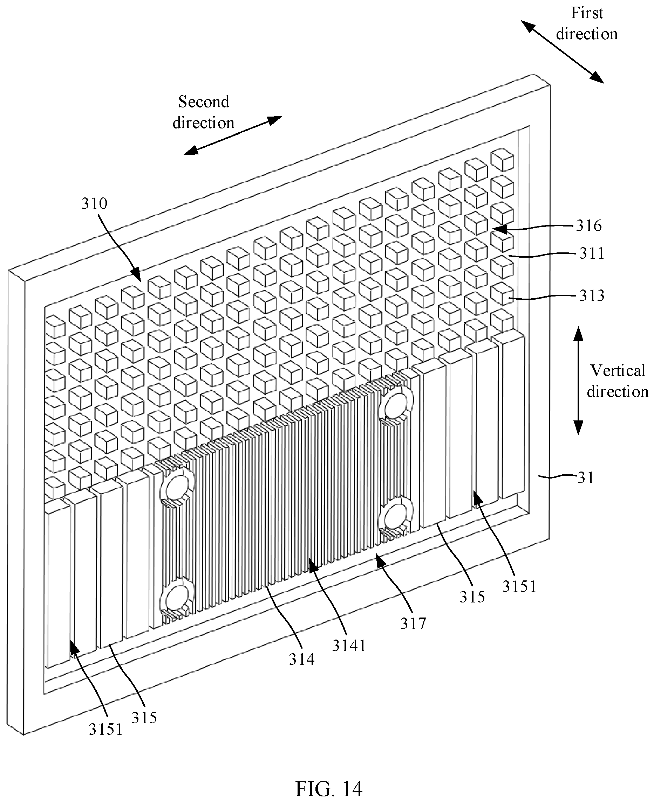

In addition, to facilitate evaporation, a structure of the first substrate 31 may be further improved. For example, FIG. 14 shows an example of another structure of the first substrate 31. With reference to FIG. 14, a first evaporation zone 314 is disposed in the first gas-liquid channel 310 of the first substrate 31. The first evaporation zone 314 is disposed opposite to the first power component 21 in the first direction (for a position of the first power component 21, refer to FIG. 5 or FIG. 7). A side that is of the first evaporation zone 314 and that faces the first power component 21 is connected to an inner wall surface of the first substrate 31. An outer wall surface corresponding to the inner wall surface that is of the first substrate 31 and that is connected to the first evaporation zone 314 is in contact with the first power component 21. In other words, a region in which the first evaporation zone 314 is disposed on the first substrate 31 is a region in which the first substrate 31 is in contact with the first power component 21.

The first gas-liquid channel 310 in the first substrate 31 includes a first cavity 316 and a second cavity 317 located on two sides of the first evaporation zone 314 in the vertical direction. A plurality of first flow channels 3141 communicating with the first cavity 316 and the second cavity 317 are disposed in the first evaporation zone 314. It may be understood that the first flow channels 3141 also belong to the first gas-liquid channel 310. In the example shown in FIG. 14, the first flow channels 3141 may be grooves provided in the first evaporation zone 314. Each groove extends in the vertical direction, so that each first flow channel 3141 extends in the vertical direction, to implement a communication between the first cavity 316 and the second cavity 317 that are distributed in the vertical direction. The plurality of first flow channels 3141 are distributed at intervals in the second direction.

Because the first power component 21 abuts against the region in which the first evaporation zone 314 is disposed on the first substrate 31, the heat of the first power component 21 is transferred to the first evaporation zone 314 through the first substrate 31. Disposing the plurality of first flow channels 3141 in the first evaporation zone 314 can increase a surface area of the first evaporation zone 314, so that a contact area of the first evaporation zone 314 and the cooling medium is larger, leading to more boiling nucleation points in the first evaporation zone 314. The cooling medium needs to flow between the first cavity 316 and the second cavity 317 through the first flow channels 3141. That is, the cooling medium flows from a lower part of the first evaporation zone 314 to an upper part of the first evaporation zone 314 through the first flow channels 3141. More boiling nucleation points help the liquid cooling medium become gaseous.

In the example shown in FIG. 14, the first evaporation zone 314 is formed by disposing the plurality of first flow channels 3141 (groove structures) on a protrusion structure inside the first substrate 31, so that the first evaporation zone 314 resembles a dense tooth structure. An inner wall surface that is of the first substrate 31 and that encloses the first gas-liquid channel 310 includes a first wall surface 311 and a second wall surface 312. FIG. 14 shows an example of only the first wall surface 311 (a wall surface close to the first power component 21). For the second wall surface 312, refer to FIG. 5. The first wall surface 311 and the second wall surface 312 are disposed opposite to each other in a thickness direction (the first direction) of the first substrate 31. The first evaporation zone 314 may be integrally connected to the first wall surface 311, so that the heat of the first power component 21 can be quickly transferred to the first evaporation zone 314. In another example, the first evaporation zone 314 may include a plurality of heat conducting sheets (such as fins). The plurality of heat conducting sheets are distributed at intervals in the second direction. The first flow channel 3141 is formed between two adjacent heat conducting sheets.

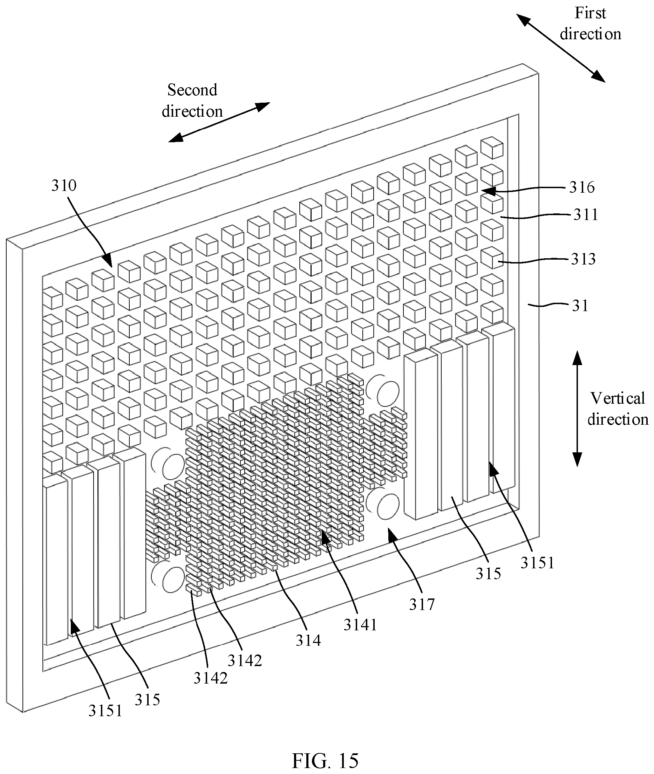

In another example, with reference to FIG. 15, which shows an example of another structure of the first evaporation zone 314, the first evaporation zone 314 includes a plurality of ribs 3142 arranged in a matrix. Any channel that is formed by the plurality of ribs 3142 arranged in a matrix and that can communicate with the first cavity 316 and the second cavity 317 is the first flow channel 3141. In this example, the first evaporation zone 314 may also be integrally connected to the first wall surface 311.

In another example, the first evaporation zone 314 is a corrugated plate that is bent for a plurality of times. In this example, the first evaporation zone 314 is an independent structure, and the first evaporation zone 314 is mounted in the first substrate 31. The first evaporation zone 314 is connected to an inner wall of the first substrate 31 through subsequent welding (or in another connection manner).

In some examples, with reference to FIG. 14 and FIG. 15, second evaporation zones 315 are disposed on two sides of the first evaporation zone 314. A distribution direction (the second direction) of the two second evaporation zones 315 is perpendicular to the vertical direction. A plurality of second flow channels 3151 communicating with the first cavity 316 and the second cavity 317 are disposed in the second evaporation zone 315. It may be understood that the second flow channels 3151 also belong to the first gas-liquid channel 310. Disposing the second flow channels 3151 can increase a surface area of the second evaporation zone 315, leading to more boiling nucleation points therein. This helps the liquid cooling medium become gaseous when the cooling medium flows through the second flow channels 3151.

The second evaporation zones 315 are away from the first power component 21. The first evaporation zone 314 is close to the first power component 21. A quantity of the second flow channels 3151 in each of the second evaporation zones 315 may be less than a quantity of the first flow channels 3141 (the first flow channels 3141 are denser), so that more cooling medium passes through the first evaporation zone 314, to help the cooling medium absorb the heat of the first power component 21. After absorbing the heat of the first power component 21, the liquid cooling medium in the second cavity 317 becomes gaseous and enters the first cavity 316 through the first flow channels 3141. Cooled and liquefied cooling medium may flow back to the second cavity 317 through the second flow channels 3151.

Because the first gas-liquid channel 310 is disposed in the first substrate 31, to reduce a possibility of deformation of the first substrate 31, in some examples, with reference to FIG. 14 and FIG. 15, the inner wall surface that is of the first substrate 31 and that encloses the first gas-liquid channel 310 includes the first wall surface 311 and the second wall surface 312. FIG. 14 and FIG. 15 show an example of only the first wall surface 311 (the wall surface close to the first power component 21). For the second wall surface 312, refer to FIG. 5. The first wall surface 311 and the second wall surface 312 are disposed opposite to each other in the thickness direction (the first direction) of the first substrate 31. A plurality of support members 313 are disposed between the first wall surface 311 and the second wall surface 312. Each support member 313 has one end connected to or abutting against the first wall surface 311 and the other end connected to or abutting against the second wall surface 312. For example, the two ends of each support member 313 are respectively connected to the first wall surface 311 and the second wall surface 312.

The support member 313 is a protrusion (bump) or another protrusion-type support structure. The support member 313 between the first wall surface 311 and the second wall surface 312 supports the first wall surface 311 and the second wall surface 312. That is, the internal cavity (the first gas-liquid channel 310) of the first substrate 31 is supported through the support member 313, to reduce a possibility that the first substrate 31 is crushed or bent, make a service life of the first substrate 31 longer, and reduce a possibility that the heat sink 3 fails due to local deformation.

In the two examples shown in FIG. 14 and FIG. 15, space of the first cavity 316 is relatively large. The plurality of support members 313 may be disposed in the first cavity 316. In some other examples, for example, in an example in which the first evaporation zone 314 and the second evaporation zones 315 are not disposed, the support member 313 may be disposed at any proper position to support the first substrate 31.

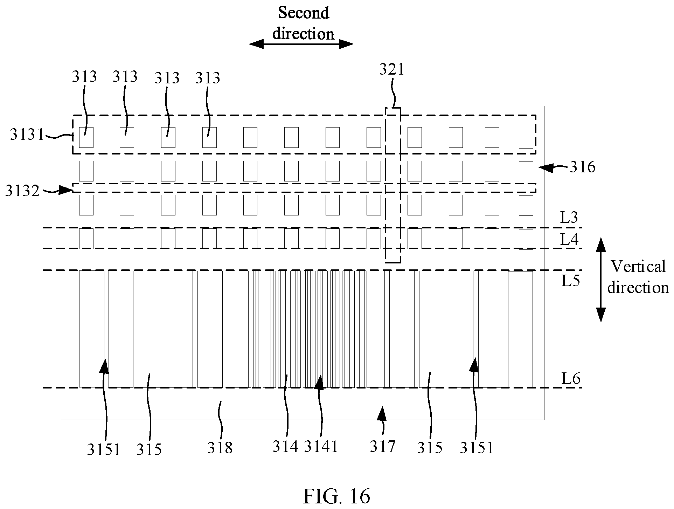

In some examples, the plurality of support members 313 are divided into a plurality of rows of support groups 3131 arranged in the vertical direction. FIG. 16 shows an example of a structure of the support group 3131. With reference to FIG. 16, the support group 3131 in each row includes a plurality of support members 313 arranged in the second direction. A flow equalization channel 3132 for the cooling medium to flow is formed between the support groups 3131 in two adjacent rows. The flow equalization channel 3132 extends in the second direction. The flow equalization channel 3132 communicates with the second gas-liquid channel 320 (for the second gas-liquid channel 320, refer to FIG. 7), so that the cooling medium in the flow equalization channel 3132 can flow to a plurality of regions of the second gas-liquid channel 320 in the second direction. For example, when the first heat dissipation portion 32 includes the plurality of first condensation pipes 321 arranged at intervals in the second direction (for example, a dashed box marked with "321" represents a position at which one first condensation pipe 321 is mounted), the flow equalization channel 3132 communicates with the plurality of first condensation pipes 321, so that the gaseous cooling medium can enter the plurality of first condensation pipes 321 for cooling, to reduce a possibility that the cooling medium is concentrated in individual first condensation pipes 321.

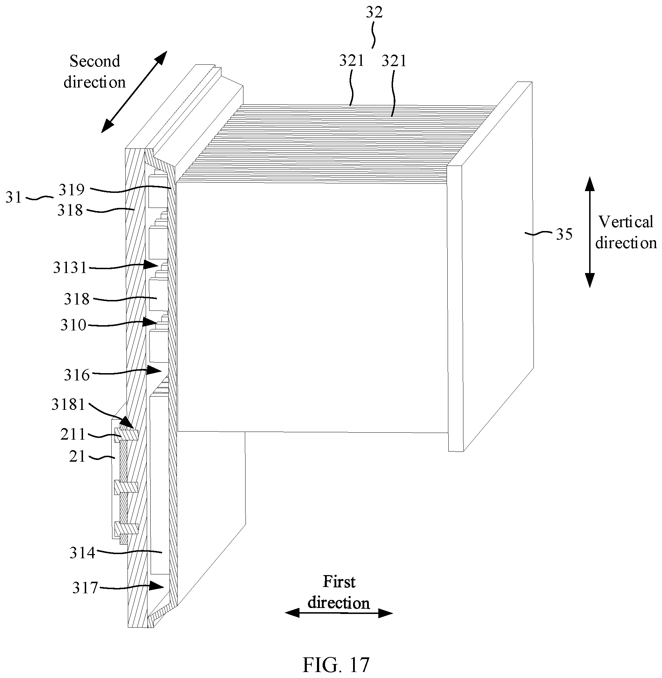

To facilitate production and manufacturing of the first substrate 31, the first substrate 31 may be divided into a plurality of parts that are separately produced and then assembled together. In some examples, the first substrate 31 includes a bottom plate 318 and a cover plate 319 that are arranged in the first direction. FIG. 17 shows an example of a structure of the bottom plate 318 and the cover plate 319. With reference to FIG. 17, the bottom plate 318 is connected to the first power component 21. The cover plate 319 is located on a side that is of the bottom plate 318 and that is away from the first power component 21. An edge of the cover plate 319 is fastened to an edge of the bottom plate 318. The cover plate 319 bulges toward a side away from the bottom plate 318. The first gas-liquid channel 310 is located between the bottom plate 318 and the cover plate 319. Each of the support members 313 has one end integrally connected to the bottom plate 318 and the other end connected to or abutting against the cover plate 319.

With reference to FIG. 16, on the bottom plate 318, surfaces that are of the plurality of support members 313 in the support group 3131 in each row and that face upward in the vertical direction are flush (for example, surfaces that are of the plurality of support members 313 in the support group 3131 in one row and that face upward in the vertical direction are all parallel to a dashed line L3). Surfaces that are of the plurality of support members 313 in the support group 3131 in each row and that face downward in the vertical direction are flush (for example, surfaces that are of the plurality of support members 313 in the support group 3131 in one row and that face downward in the vertical direction are all parallel to a dashed line L4). For each of the support members 313, the surface facing upward in the vertical direction is parallel to the surface facing downward in the vertical direction. In this way, the bottom plate 318 and the plurality of support groups 3131 thereon may be produced through extrusion molding, and then each support group 3131 may be divided into the plurality of support members 313 through turning processing (or in another processing manner). This helps improve production and processing efficiency of the first substrate 31.

With reference to FIG. 16 and FIG. 17, when the first evaporation zone 314 and the second evaporation zones 315 are disposed in the first gas-liquid channel 310, the first evaporation zone 314 and the second evaporation zones 315 may also be integrally connected to the bottom plate 318. In addition, in some examples, a surface (a surface facing upward in the vertical direction) that is of the first evaporation zone 314 and that faces the first cavity 316 and a surface (a surface facing upward in the vertical direction) that is of each second evaporation zone 315 and that faces the first cavity 316 are flush (for example, both parallel to a dashed line L5), and a surface (a surface facing downward in the vertical direction) that is of the first evaporation zone and that faces the second cavity 317 and a surface (a surface facing downward in the vertical direction) that is of each second evaporation zone 315 and that faces the second cavity 317 are flush (for example, both parallel to a dashed line L6). In this way, the first evaporation zone 314 and the second evaporation zones 315 may also be formed on the bottom plate 318 through extrusion molding, and then the first flow channels 3141 may be formed in the first evaporation zone 314 and the second flow channels 3151 may be formed in the second evaporation zones 315 through turning processing (or in another processing manner).

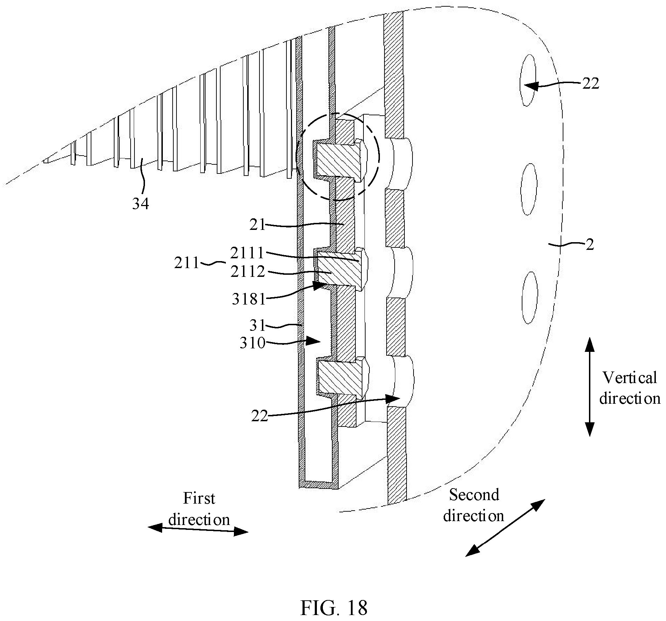

To better transfer the heat of the first power component 21 to the first substrate 31, the first power component 21 may be fastened to the first substrate 31, so that the first power component 21 is in sufficient contact with the first substrate 31, to reduce a possibility of a gap between contact surfaces of the first power component 21 and the first substrate 31. For example, FIG. 18 shows an example of a fastening manner.

With reference to FIG. 18, the first power component 21 may be fastened to the first substrate 31 through a bolt 211. The circuit board 2 is provided with a through hole 22. The through hole 22 is used for a head portion 2111 of the bolt 211 to pass through. A rod portion 2112 of the bolt 211 passes through the first power component 21 and is threaded to the first substrate 31 (the first substrate 31 is provided with a threaded hole 3181 for the bolt 211 to be threaded). The head portion 2111 of the bolt 211 abuts against a surface that is of the first power component 21 and that is away from the first substrate 31, so that the first power component 21 can be closely attached to the first substrate 31, to achieve better heat dissipation effect for the first power component 21. A plurality of bolts 211 may be disposed, and a plurality of corresponding through holes 22 may also be provided.

In the example shown in FIG. 18, the rod portion 2112 of the bolt 211 does not extend into or pass through the first gas-liquid channel 310. In addition, the head portion 2111 of the bolt 211 abuts against the first power component 21 rather than the circuit board 2. This reduces a possibility of damage to the circuit board 2 during mounting and fastening through the bolt 211, and impact exerted on the circuit board 2 when the first power component 21 is connected to the first substrate 31.

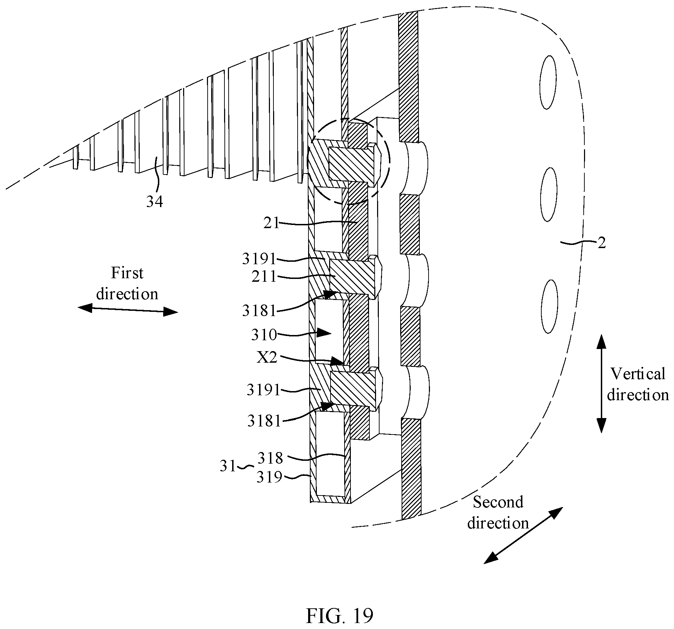

With reference to FIG. 18, it may be understood that the threaded hole 3181 for the bolt 211 to be threaded on the first substrate 31 is a blind hole. In addition, the threaded hole 3181 is formed on a surface that is of the first substrate 31 and that faces the first power component 21. For example, when the first substrate 31 includes the bottom plate 318 and the cover plate 319 (with auxiliary reference to FIG. 17), the threaded hole 3181 is formed on a surface that is of the bottom plate 318 and that is away from the cover plate 319. In addition, FIG. 19 shows an example of another structure of the threaded hole 3181. With reference to FIG. 19, the first substrate 31 includes a bottom plate 318 and a cover plate 319. A boss 3191 is disposed on the cover plate 319. The threaded hole 3181 is formed in the boss 3191. The boss 3191 extends toward the first power component 21 and passes through the bottom plate 318, so that the threaded hole 3181 is exposed. The bolt 211 passes through the first power component 21 and is threaded to the threaded hole 3181 in the boss 3191. If a solution of the threaded hole 3181 in FIG. 19 is used, because the boss 3191 needs to pass through the bottom plate 318, the boss 3191 needs to be welded to the bottom plate 318 for sealing (for example, welding needs to be performed at a position indicated by an arrow X2), to reduce a possibility of leakage of the cooling medium in the first gas-liquid channel 310. However, in a solution of the threaded hole 3181 in FIG. 17 and FIG. 18, the threaded hole 3181 is provided on the surface that is of the first substrate 31 and that faces the first power component 21 in a form of a blind hole, so that circumferential sealing welds of the bolt 211 can be reduced.

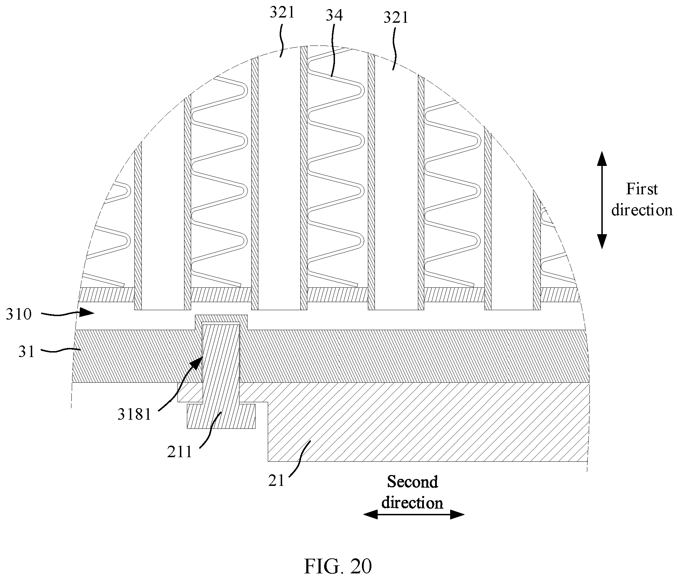

In some examples, with reference to FIG. 18 and FIG. 19, the first substrate 31 extends in the vertical direction and protrudes from the first heat dissipation portion 32 (protrudes downward from the first heat dissipation portion 32). The first power component 21 is in thermal contact with a part that is of the first substrate 31 and that protrudes from the first heat dissipation portion 32. The first power component 21 has a part extending below the first heat dissipation portion 32 and the other part facing the first heat dissipation portion 32 in the first direction. That is, the first heat dissipation portion 32 and the first power component 21 have an overlapping region in the first direction. In this way, at least one bolt 211 faces the first heat dissipation portion 32 in the first direction. For example, the bolt 211 circled by a dashed circle in FIG. 18 and FIG. 19 faces the first heat dissipation portion 32 in the first direction. In some examples, positions of such a bolt 211 and a corresponding threaded hole 3181 may be adjusted to reduce a thickness of the first substrate 31. For example, FIG. 20 shows an example of a structure of the threaded hole 3181. With reference to FIG. 20, the first heat dissipation portion 32 includes a plurality of first condensation pipes 321 arranged at intervals in the second direction. Each first condensation pipe 321 passes through a side wall that is of the first substrate 31 and that is away from the first power component 21 and extends into the first gas-liquid channel 310. If a region in which the threaded hole 3181 is provided on the first substrate 31 protrudes toward a side away from the first power component 21 into the first gas-liquid channel 310 (forming a boss protruding into the first gas-liquid channel 310), the position of the threaded hole 3181 (namely, the position of the bolt 211) may face a region (for example, a region in which the fins 34 are located) between two adjacent first condensation pipes 321 in the first direction. In this way, the bolt 211 and a part that is of the first condensation pipe 321 and that extends into the first gas-liquid channel 310 can be staggered, to reduce the thickness of the first substrate 31 while ensuring that the cooling medium can smoothly flow in the first gas-liquid channel 310.

The circuit board 2 is disposed in the power cavity 111. When the power conversion device 100 operates, the circuit board 2 and the components on the circuit board 2 heat up severely, and the temperature in the power cavity 111 is high. Therefore, heat dissipation needs to be performed for the power cavity 111. In other words, heat dissipation needs to be performed for the circuit board 2 and the components (for example, the electronic components 25 in FIG. 2) on the circuit board 2. With reference to FIG. 3 and FIG. 4, the power conversion device 100 may further include a first heat exchanger 4. The first heat exchanger 4 is configured to transfer the heat in the power cavity 111 to the heat dissipation cavity 112, to dissipate heat for the electronic components 25.

In an example, the first heat exchanger 4 is disposed in the heat dissipation cavity 112. A heat exchange channel in the first heat exchanger 4 communicates with the power cavity 111. A first heat exchange channel (located in the first heat exchanger 4 and therefore not shown in the figure) is formed in the first heat exchanger 4. The first heat exchange channel is isolated from the heat dissipation cavity 112. The first heat exchange channel has an inlet and an outlet (blocked and therefore not shown in the figure) provided on the first heat exchanger 4. Both the inlet and the outlet of the first heat exchange channel communicate with the power cavity 111. For example, the inlet and the outlet of the first heat exchange channel communicate with corresponding mounting openings 114 on the separator 11, so that the first heat exchange channel in the first heat exchanger 4 communicates with the power cavity 111.

The first heat exchanger 4 may enable the hot air in the power cavity 111 to enter the first heat exchange channel in the first heat exchanger 4, and then exchange heat with the air in the heat dissipation cavity 112 in the first heat exchanger 4. The heat sink 3 communicates with the outside through the heat dissipation hole 121, so that the air in the heat dissipation cavity 112 exchanges heat with the outside. In this way, the first heat exchanger 4 can efficiently dissipate heat in the heat dissipation cavity 112, to reduce the temperature in the power cavity 111 and enable the power conversion device 100 to operate stably.

With reference to FIG. 4, the first heat exchanger 4 includes a fin heat exchanger. For example, the first heat exchanger 4 includes a plurality of first flat heat dissipation pipes 41 and a plurality of first heat dissipation sheets 42 (for example, having a fin-like structure). The plurality of first flat heat dissipation pipes 41 are distributed at intervals in the first direction. The plurality of first heat dissipation sheets 42 are disposed between two adjacent first flat heat dissipation pipes 41. Internal space of the plurality of first flat heat dissipation pipes 41 forms the first heat exchange channel in the first heat exchanger 4. In another example, the first heat exchange channel in the first heat exchanger 4 includes an "S"-like or snake-like channel.

With reference to FIG. 3 and FIG. 4, the first heat exchanger 4 is at least partially located between the first heat dissipation portion 32 and a part that is of the first substrate 31 and that protrudes from the first heat dissipation portion 32. In other words, the part that is of the first substrate 31 and that protrudes below the first heat dissipation portion 32 encloses an accommodating space 33 with the first heat dissipation portion 32. The first heat exchanger 4 is at least partially disposed in the accommodating space 33. For example, the first heat exchanger 4 is located on a side that is of the first substrate 31 and that is away from the separator 11. The first heat exchanger 4 is located below the first heat dissipation portion 32. The first heat exchanger 4 is mounted in the accommodating space 33, and the first heat exchanger 4 crosses the first substrate 31 and overlaps the part that is of the first substrate 31 and that protrudes from the first heat dissipation portion 32 in the first direction, so that the heat sink 3 and the first heat exchanger 4 can be mounted more compactly, to reduce space occupied by the heat dissipation cavity 112.

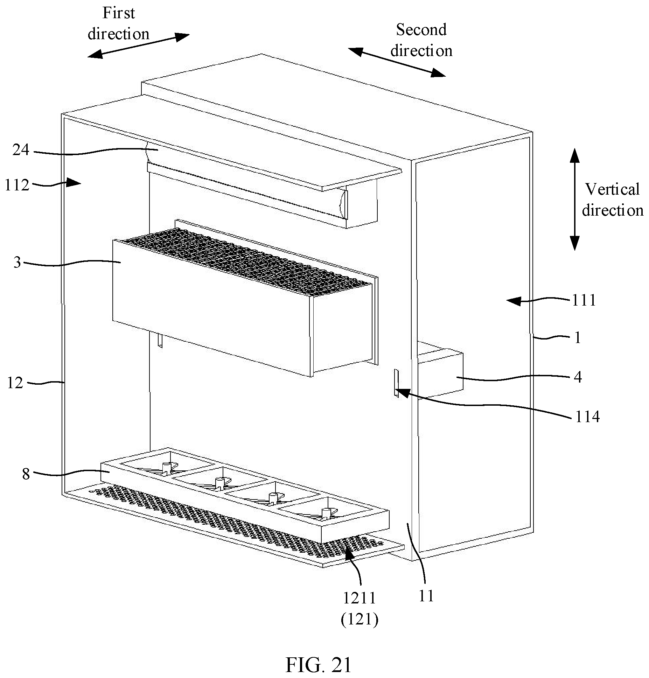

In some other examples, with reference to FIG. 21, which shows an example of another position at which the first heat exchanger 4 is disposed, the first heat exchanger 4 is located in the power cavity 111. The first heat exchange channel in the first heat exchanger 4 is isolated from the power cavity 111. The first heat exchange channel has an inlet and an outlet that are provided on the first heat exchanger 4. The inlet and the outlet of the first heat exchange channel communicate with the heat dissipation cavity 112 through corresponding mounting openings 114 on the separator 11.

In the foregoing design manner, the air in the heat dissipation cavity 112 may enter the first heat exchange channel in the first heat exchanger 4, and then exchange heat with the hot air in the power cavity 111 through the first heat exchanger 4. In addition, the heat dissipation cavity 112 is open and ventilated. In this way, external air can continuously enter the first heat exchange channel in the first heat exchanger 4, to reduce the temperature in the power cavity 111 and enable the power conversion device 100 to operate stably.

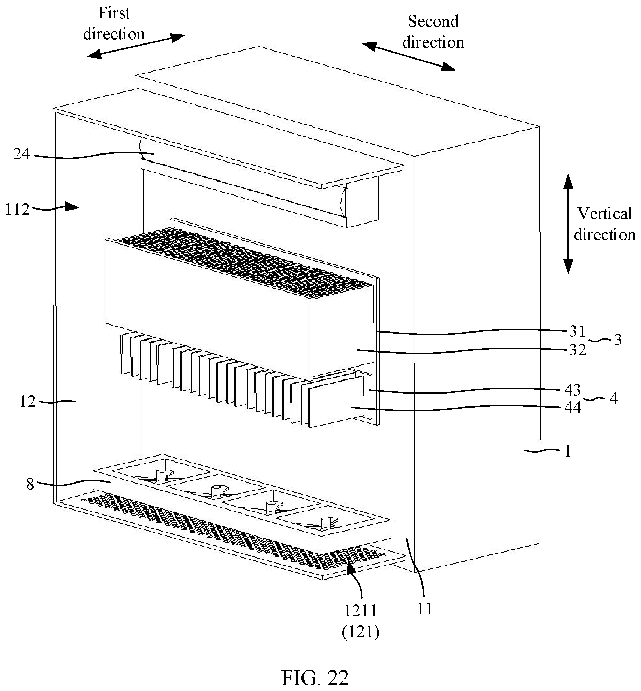

In some other examples, with reference to FIG. 22, which shows an example of still another position at which the first heat exchanger 4 is disposed, the first heat exchanger 4 is located in the heat dissipation cavity 112. The first heat exchanger 4 includes a plurality of heat dissipation fins 44 and a heat conducting plate 43 that are connected to each other. The heat conducting plate 43 is thermally attached to the first substrate 31. The plurality of heat dissipation fins 44 are fastened in the second direction to a side that is of the heat conducting plate 43 and that is away from the first substrate 31. A first fan 8 is disposed in the heat dissipation cavity 112. The first fan 8 is configured to generate airflow to pass through the heat dissipation fin 44.

When a temperature of the electronic component 25 increases, the temperature in the power cavity 111 increases. The heat in the power cavity 111 is transferred to the heat conducting plate 43 through the first substrate 31. Then, the heat conducting plate 43 transfers the heat to the heat dissipation fin 44. The first fan 8 blows air toward the heat dissipation fin 44, and the heat dissipation cavity 112 is open and ventilated, so that heat on the heat dissipation fin 44 can be blown out of the heat dissipation cavity 112 (or out of the protective cover 12) through the air, that is, blown to the outside. The first fan 8 rotates to dissipate the heat on the heat dissipation fin 44, that is, implement indirect heat dissipation for the electronic component 25 in the power cavity 111.

In an example in which the first substrate 31 protrudes downward from the first heat dissipation portion 32, with reference to FIG. 22, the heat conducting plate 43 is thermally attached to a part that is of the first substrate 31 and that protrudes from the first heat dissipation portion 32. The heat dissipation fin 44 is located below the first heat dissipation portion 32. The first substrate 31 extends downward and encloses a space (which may be the accommodating space 33 in FIG. 4) with the first heat dissipation portion 32. The first heat exchanger 4 is mounted in the space, so that the heat sink 3 and the first heat exchanger 4 can be mounted more compactly, to reduce space occupied by the heat dissipation cavity 112. In addition, the first power component 21 is in contact with the protruding part of the first substrate 31 (with reference to FIG. 5), and the heat conducting plate 43 is also in contact with the protruding part of the first substrate 31, to assist in heat dissipation for the first power component 21 in cooperation with the heat dissipation fin 44.

In some examples, with reference to FIG. 22, the power component further includes a component that heats up severely, such as an inductor 24 (different from the inductor in the plurality of electronic components 25). The component that heats up severely, such as the inductor 24, may be disposed in the heat dissipation cavity 112, and is fastened to the separator 11, to facilitate heat dissipation of the component. The component that heats up severely, such as the inductor 24, may be electrically connected to the circuit board 2 through a wire. The wire passes through the separator 11. To properly utilize space in the heat dissipation cavity 112, the inductor 24 may be located above the first substrate 31.

In addition, to facilitate heat dissipation, in an example, with reference to FIG. 1 and FIG. 2, the power conversion device 100 further includes a first fan 8. The heat dissipation hole 121 includes an air inlet hole 1211 and an air outlet hole 1212. One of the air inlet hole 1211 and the air outlet hole 1212 is located below the heat sink 3, and the other is located above the heat sink 3. In other words, the air inlet hole 1211 and the air outlet hole 1212 are respectively located on upper and lower sides of the heat sink 3. The first fan 8 is configured to drive air that enters through the air inlet hole 1211 to be discharged from the air outlet hole 1212. Under the effect of the first fan 8, air outside the protective cover 12 enters through the air inlet hole 1211, passes through the heat sink 3, and is discharged from the air outlet hole 1212, so that external air can fully pass through the heat sink 3, to improve heat dissipation effect of the heat sink 3.

For example, the air inlet hole 1211 is provided below the heat sink 3, and the air outlet hole 1212 is provided above the heat sink 3. In the heat dissipation cavity 112, the temperature of the air after heat exchange with the heat exchanger and the heat sink 3 is high. A density of hot air is lower than that of cold air. For a same volume, hot air is lighter than cold air, so that the hot air rises. Therefore, the air inlet hole 1211 is provided below the air outlet hole 1212. This better complies with a flow rule of the air in the heat dissipation cavity 112, and achieves better heat dissipation effect in the heat dissipation cavity 112.

A plurality of air inlet holes 1211 and air outlet holes 1212 may be provided. In some examples, the air inlet hole 1211 and the air outlet hole 1212 have a same shape and size.

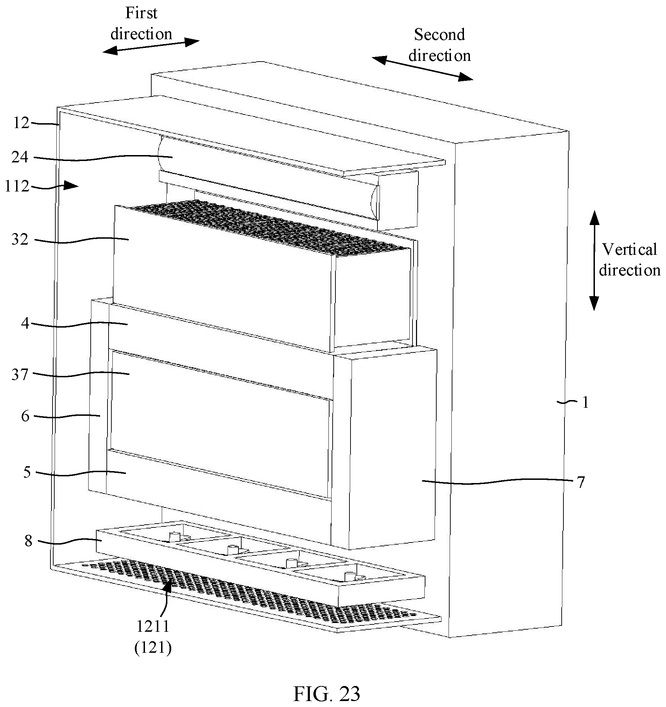

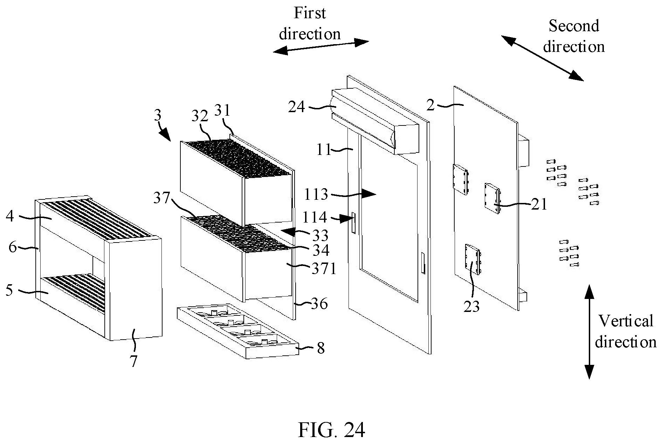

FIG. 23 shows an example of an internal structure of another power conversion device 100. FIG. 24 shows an example of an exploded view of a partial structure of the power conversion device 100 in FIG. 23. A structure of a housing 1 and a structure of a protective cover 12 in this example may be the same as the structure of the housing 1 and the structure of the protective cover 12 shown in FIG. 1. In the examples shown in FIG. 23 and FIG. 24, in addition to the first substrate 31 and the first heat dissipation portion 32, the heat sink 3 further includes a second substrate 36 and a second heat dissipation portion 37. The second substrate 36 and the first substrate 31 are distributed in the vertical direction and fastened together.

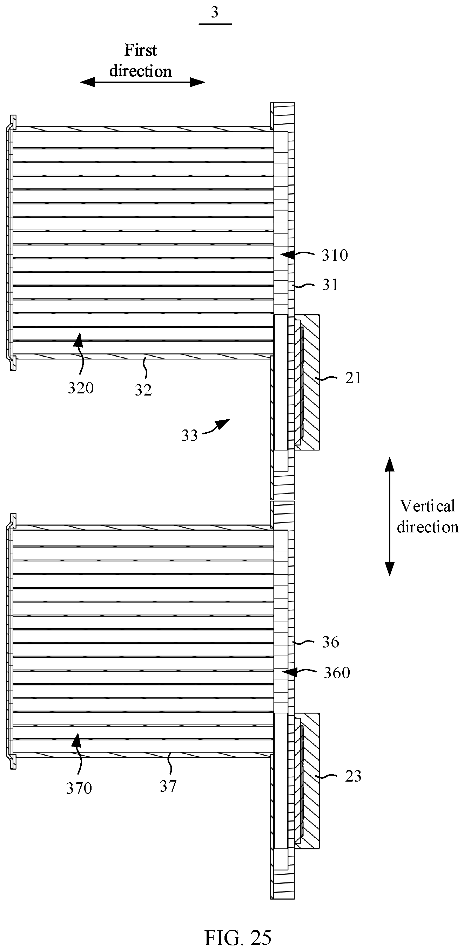

FIG. 25 shows an example of internal cavities of the second substrate 36 and the second heat dissipation portion 37. With reference to FIG. 24 and FIG. 25, a third gas-liquid channel 360 is disposed in the second substrate 36. A cooling medium used for gas-liquid conversion is disposed in the third gas-liquid channel 360 of the second substrate 36. A fourth gas-liquid channel 370 communicating with the third gas-liquid channel 360 is disposed in the second heat dissipation portion 37. The third gas-liquid channel 360 is isolated from the first gas-liquid channel 310. The second substrate 36 and the first substrate 31 do not communicate with each other. In addition, the second heat dissipation portion 37 is disposed on a side that is of the second substrate 36 and that is away from the separator 11.

With reference to FIG. 24, in addition to the first power component 21, a second power component 23 is further disposed on the side that is of the circuit board 2 and that faces the opening 113. In some examples, the second power component 23 may also form a power conversion circuit of the power conversion device 100, to perform power conversion on a direct current input to the power conversion device 100. For example, the second power component 23 includes a chip. In another example, the second power component 23 may alternatively be a power component with another function on the circuit board 2. The second power component 23 is in contact with the second substrate 36. When heat dissipation is needed for a large quantity of power components on the circuit board 2, and there is a height difference between different power components (the first power component 21 and the second power component 23), the second substrate 36 and the second heat dissipation portion 37 can better dissipate heat for the second power component 23, to reduce a possibility that normal operating of the power conversion device 100 is affected because the second power component 23 heats up severely.

After the first substrate 31 is connected to the second substrate 36, the opening 113 is shielded, to reduce a possibility that the air in the heat dissipation cavity 112 enters the power cavity 111. In addition, the power cavity 111 (for example, the inside of the housing 1 in FIG. 23) and the heat dissipation cavity 112 are distributed in the first direction, and the first substrate 31 and the second substrate 36 are distributed in the vertical direction. This can reduce a dimension of the heat sink 3 in the first direction, that is, reduce a dimension of the heat dissipation cavity 112 in the first direction, to reduce a dimension of the power conversion device 100 in the first direction.

With reference to FIG. 25, the second substrate 36 protrudes downward from the second heat dissipation portion 37. The second power component 23 is partially located below the second heat dissipation portion 37. An overlapping region of the second heat dissipation portion 37 and the second power component 23 is reduced, so that the second heat dissipation portion 37 can have a larger region for heat exchange with the air in the heat dissipation cavity 112. This helps improve heat dissipation effect. In another example, the second power component 23 is completely located below the second heat dissipation portion 37. That is, the second power component 23 and the second heat dissipation portion 37 are located on two sides of the second substrate 36, and there is a spacing between the second power component 23 and the second heat dissipation portion 37 in the vertical direction.

In some examples, with reference to FIG. 25, a structure of the second substrate 36 may be the same as that of the first substrate 31. In another example, the second substrate 36 has another structure that can play a same role as the first substrate 31. In addition, dimensions of the first substrate 31 and the second substrate 36 may be the same or different. This is not specifically limited in this application. In the examples shown in FIG. 23 to FIG. 25, the first substrate 31 is located above the second substrate 36. In these examples, the first heat dissipation portion 32 is also located above the second heat dissipation portion 37. In another example, the first substrate 31 may alternatively be located below the second substrate 36. In this example, the first heat dissipation portion 32 is also located below the second heat dissipation portion 37.

With reference to FIG. 24, the second heat dissipation portion 37 may include a plurality of second condensation pipes 371 arranged at intervals. A plurality of fins 34 (similar to a structure of the first heat dissipation portion 32 in FIG. 6) are disposed between two adjacent second condensation pipes 371. In the first heat dissipation portion 32 and the second heat dissipation portion 37, a quantity of fins 34 disposed on the one close to the air inlet hole 1211 is less than a quantity of fins 34 disposed on the one away from the air inlet hole 1211.

Because air at the air inlet hole 1211 just enters the heat dissipation cavity 112 from the outside, air closer to the air inlet hole 1211 has a lower temperature. When the air passes through the one close to the air inlet hole 1211 in the first heat dissipation portion 32 and the second heat dissipation portion 37, heat exchange is performed. A temperature of the air after the heat exchange increases. In other words, in the heat dissipation cavity 112, air closer to the air outlet hole 1212 has a higher temperature. In the first heat dissipation portion 32 and the second heat dissipation portion 37, sparse fins 34 are arranged on the one close to the air inlet hole 1211, so that a large amount of air passes, and more air is blown to the one away. Dense fins 34 are arranged on the one away from the air inlet hole 1211, to enhance a heat dissipation capability. In this way, the first heat dissipation portion 32 and the second heat dissipation portion 37 that are vertically arranged can evenly dissipate heat.

With reference to FIG. 23 and FIG. 24, an example in which the air inlet hole 1211 is located below the heat sink 3 is used. If the first heat dissipation portion 32 is located above the second heat dissipation portion 37, the fins 34 of the second heat dissipation portion 37 are more sparse than those of the first heat dissipation portion 32. In other words, the fins 34 of the first heat dissipation portion 32 are denser than those of the second heat dissipation portion 37. In an example in which the air inlet hole 1211 is located above the heat sink 3, if the first heat dissipation portion 32 is located above the second heat dissipation portion 37, the fins 34 of the second heat dissipation portion 37 are denser than those of the first heat dissipation portion 32. In other words, the fins 34 of the first heat dissipation portion 32 are more sparse than those of the second heat dissipation portion 37.

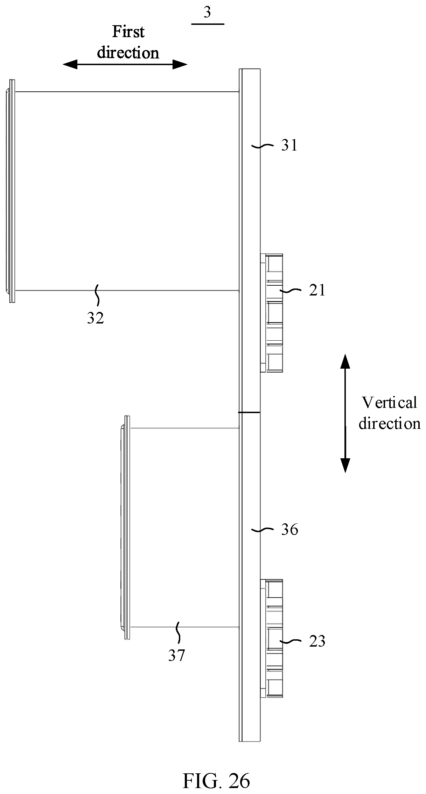

In some other examples, FIG. 26 shows an example of another manner of disposing the first heat dissipation portion 32 and the second heat dissipation portion 37. In this example, in the first heat dissipation portion 32 and the second heat dissipation portion 37, a dimension of the one close to the air inlet hole 1211 in the first direction is less than a dimension of the one away from the air inlet hole 1211 in the first direction. In other words, the heat dissipation portion close to the air inlet hole 1211 is shorter in the first direction. In an arrangement manner with different lengths, more cold air can be blown to the one away from the air inlet hole 1211 in the first heat dissipation portion 32 and the second heat dissipation portion 37, to enhance a heat dissipation capability of the heat sink 3 and enable the first heat dissipation portion 32 and the second heat dissipation portion 37 that are vertically arranged to evenly dissipate heat.

In the example shown in FIG. 26, the fins 34 may not be disposed. Alternatively, the fins 34 may be disposed in the first heat dissipation portion 32 and the second heat dissipation portion 37. In addition, a density of the fins 34 in the first heat dissipation portion 32 and the second heat dissipation portion 37 may be set based on a distance from the air inlet hole 1211. Details are not described herein again.

With reference to FIG. 23 and FIG. 24, in addition to the first heat exchanger 4, the power conversion device 100 further includes a second heat exchanger 5 disposed in the heat dissipation cavity 112. The second heat exchanger 5 is configured to transfer the heat in the power cavity 111 to the heat dissipation cavity 112, to dissipate heat for the electronic component 25. For example, a second heat exchange channel (located in the second heat exchanger 5 and therefore not shown in the figure) is disposed in the second heat exchanger 5. The second heat exchange channel communicates with the power cavity 111 (located in the housing 1). The hot air in the power cavity 111 may exchange heat with the air in the heat dissipation cavity 112 through the first heat exchanger 4 and the second heat exchanger 5, so that the temperature in the power cavity 111 is further reduced, and the power conversion device 100 can operate stably.

With reference to FIG. 23, because the first substrate 31 protrudes downward from the first heat dissipation portion 32, and the second substrate 36 extends downward from the second heat dissipation portion 37, there is spare space below both the first heat dissipation portion 32 and the second heat dissipation portion 37. One of the first heat exchanger 4 and the second heat exchanger 5 is disposed between the first heat dissipation portion 32 and the second heat dissipation portion 37, and the other is located below the lower one of the first heat dissipation portion 32 and the second heat dissipation portion 37.

In other words, when the first heat exchanger 4 and the second heat exchanger 5 are disposed, the spare space below the first heat dissipation portion 32 and the second heat dissipation portion 37 is fully utilized, so that the heat sink 3, the first heat exchanger 4, and the second heat exchanger 5 are mounted more compactly, and space of the heat dissipation cavity 112 in the vertical direction is fully utilized, to reduce the dimension of the power conversion device 100 in the first direction.

For example, in the example shown in FIG. 23, the first heat dissipation portion 32 is located above the second heat dissipation portion 37. The accommodating space 33 is located between the first heat dissipation portion 32 and the second heat dissipation portion 37 (with auxiliary reference to FIG. 24). The first heat exchanger 4 is disposed between the first heat dissipation portion 32 and the second heat dissipation portion 37. The second heat exchanger 5 is disposed below the second heat dissipation portion 37. In another example, the first heat dissipation portion 32 is located below the second heat dissipation portion 37. The second heat exchanger 5 is disposed between the first heat dissipation portion 32 and the second heat dissipation portion 37. The first heat exchanger 4 is disposed below the first heat dissipation portion 32.

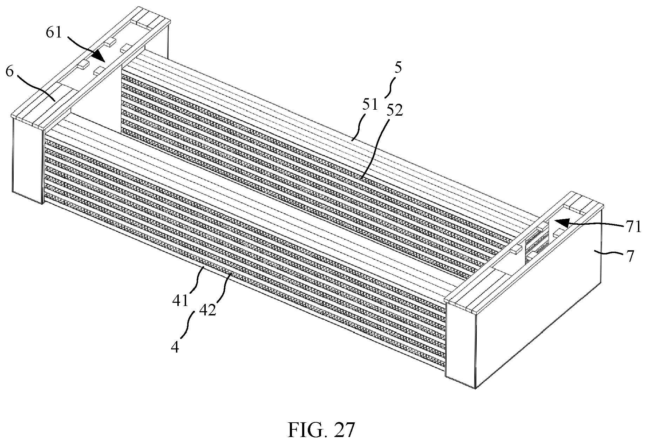

In an example, to facilitate unified mounting of the first heat exchanger 4 and the second heat exchanger 5, the first heat exchanger 4 and the second heat exchanger 5 may be connected. FIG. 27 shows an example of this structure. With reference to FIG. 27, both an inlet of the first heat exchange channel in the first heat exchanger 4 and an inlet of the second heat exchange channel in the second heat exchanger 5 communicate with a first connecting pipe 6. Both an outlet of the heat exchange channel in the first heat exchanger 4 and an outlet of the heat exchange channel in the second heat exchanger 5 communicate with a second connecting pipe 7. Both the first connecting pipe 6 and the second connecting pipe 7 communicate with the power cavity 111.

The first heat exchanger 4 communicates with and is fastened to the second heat exchanger 5 through the first connecting pipe 6 and the second connecting pipe 7, to improve a degree of integration of the first heat exchanger 4 and the second heat exchanger 5. The first heat exchanger 4 and the second heat exchanger 5 do not need to be separately mounted or separately communicate with the power cavity 111, to facilitate unified assembly and disassembly of the first heat exchanger 4 and the second heat exchanger 5 in the heat dissipation cavity 112.

The first connecting pipe 6 is provided with a heat exchange inlet 61. The second connecting pipe 7 is provided with a heat exchange outlet 71. The heat exchange inlet 61 and the heat exchange outlet 71 communicate with corresponding mounting openings 114 on the separator 11 (with reference to FIG. 24), so that the heat exchange channel in the first heat exchanger 4 and the heat exchange channel in the second heat exchanger 5 communicate with the power cavity 111. The hot air in the power cavity 111 enters the first heat exchanger 4 and the second heat exchanger 5 through the first connecting pipe 6. The hot air in the first heat exchanger 4 and the second heat exchanger 5 exchanges heat with the air in the heat dissipation cavity 112, then enters the second connecting pipe 7, and enters the power cavity 111 through the second connecting pipe 7.

In an example, with reference to FIG. 23, both the first heat exchange channel in the first heat exchanger 4 and the second heat exchange channel in the second heat exchanger 5 extend in the second direction. The first connecting pipe 6 and the second connecting pipe 7 are located on different sides of the lower one of the first heat dissipation portion 32 and the second heat dissipation portion 37 in the second direction. For example, in the example shown in FIG. 23, the first heat dissipation portion 32 is located above the second heat dissipation portion 37, and the first connecting pipe 6 and the second connecting pipe 7 are located on different sides of the second heat dissipation portion 37 in the second direction.

In the foregoing design manner, the first heat dissipation portion 32, the first heat exchanger 4, the second heat dissipation portion 37, and the second heat exchanger 5 are alternately distributed. Space above and below the lower one of the first heat dissipation portion 32 and the second heat dissipation portion 37 is respectively utilized by the first heat exchanger 4 and the second heat exchanger 5. Space on two sides of the lower one of the first heat dissipation portion 32 and the second heat dissipation portion 37 is respectively utilized by the first connecting pipe 6 and the second connecting pipe 7. In this way, space of the heat dissipation cavity 112 can be more fully utilized, to reduce a volume of the power conversion device 100.

In an example, with reference to FIG. 27, the second heat exchanger 5 includes a fin heat exchanger. For example, the second heat exchanger 5 includes a plurality of second flat heat dissipation pipes 51 and a plurality of second heat dissipation sheets 52 (for example, having a fin-like structure). The plurality of second flat heat dissipation pipes 51 are distributed at intervals in the first direction. The plurality of second heat dissipation sheets 52 are disposed between two adjacent second flat heat dissipation pipes 51 in each group. Internal space of the plurality of second flat heat dissipation pipes 51 forms the second heat exchange channel in the second heat exchanger 5. In another example, the second heat exchange channel in the second heat exchanger 5 includes an "S"-like or snake-like channel.

In some examples, to allow air in the power cavity 111 to flow in the first heat exchanger 4 and the second heat exchanger 5, a drive fan (not shown in the figure) may be disposed in the power cavity 111 so that the air is driven to flow.

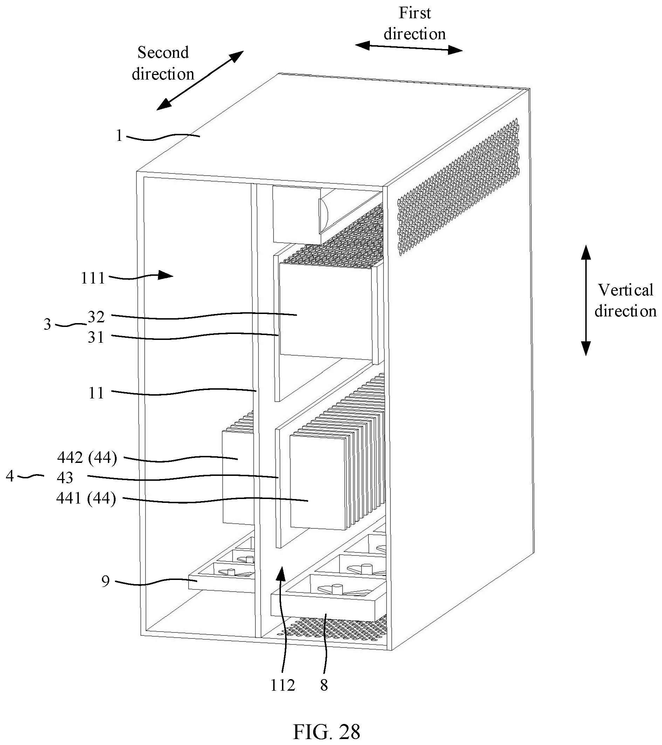

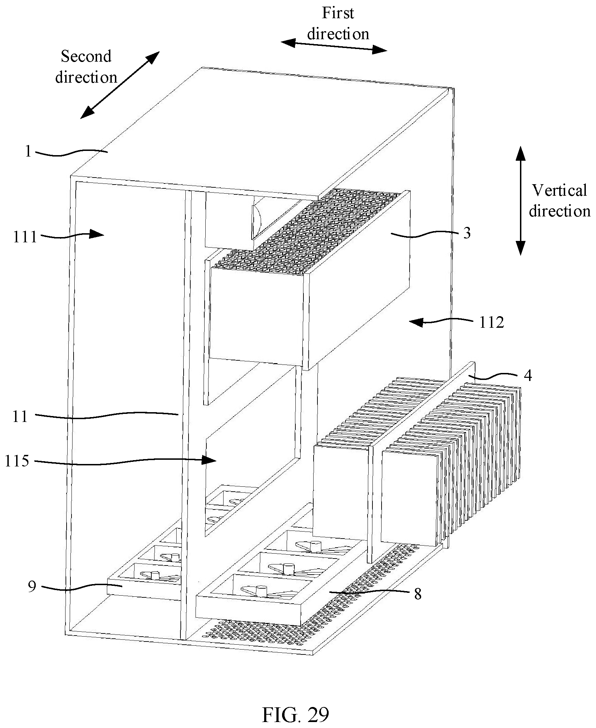

In some other examples, a structure and a position of the first heat exchanger 4 may be further adjusted based on a requirement. For example, FIG. 28 shows an example of an internal structure of still another power conversion device 100, and FIG. 29 shows an example of an exploded view of a partial structure of the power conversion device 100 in FIG. 28. With reference to FIG. 28 and FIG. 29, the separator 11 is provided with a through opening 115. The first heat exchanger 4 includes a heat conducting plate 43 (for example, a metal plate) and a plurality of heat dissipation fins 44 (for example, metal sheets). The plurality of heat dissipation fins 44 include a plurality of first heat dissipation fins 441 and a plurality of second heat dissipation fins 442. The heat conducting plate 43 is disposed at the through opening 115. The first heat dissipation fins 441 and the second heat dissipation fins 442 are fastened to different surfaces of the heat conducting plate 43. In addition, the plurality of first heat dissipation fins 441 are arranged at intervals in the second direction, and the plurality of second heat dissipation fins 442 are arranged at intervals in the second direction. The heat conducting plate 43 and the first heat dissipation fins 441 are located in the heat dissipation cavity 112. The second heat dissipation fins 442 extend into the power cavity 111 through the through opening 115.

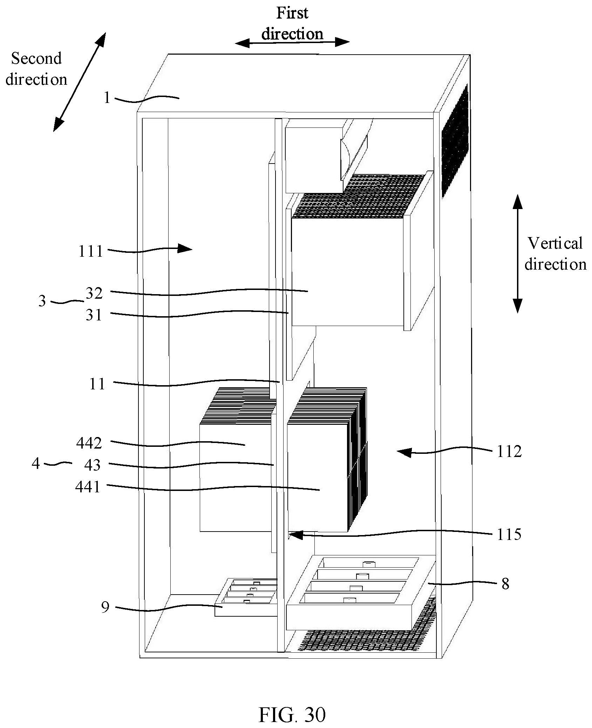

In some other examples, FIG. 30 shows an example of an internal structure of yet another power conversion device 100. The heat conducting plate 43 and the second heat dissipation fins 442 are located in the power cavity 111. The first heat dissipation fins 441 extends into the heat dissipation cavity 112 through the through opening 115.

With reference to any one of FIG. 28 to FIG. 30, a second fan 9 is disposed in the heat dissipation cavity 112. The second fan 9 is configured to generate airflow to pass through the first heat dissipation fins 441. Disposing the second fan 9 makes air in the power cavity 111 flow, so that the heat in the power cavity 111 can be continuously conducted to the second heat dissipation fins 422, and transferred outward through the second heat dissipation fins 422.

In addition, with reference to any one of FIG. 28 to FIG. 30, a first fan 8 may be further disposed in the heat dissipation cavity 112. The first fan 8 is configured to generate airflow to pass through the first heat dissipation fins 441. After the temperature in the power cavity 111 increases, the heat in the power cavity 111 is transferred to the heat conducting plate 43 through the second heat dissipation fins 442, and the heat conducting plate 43 transfers the heat to the first heat dissipation fins 441. The first fan 8 blows air toward the first heat dissipation fins 441, so that heat on the first heat dissipation fins 441 can be blown out of the heat dissipation cavity 112 through the air, that is, blown to the outside, to continuously dissipate the heat on the first heat dissipation fins 441, that is, dissipate the heat in the power cavity 111. In this way, the internal temperature in the power cavity 111 is reduced.

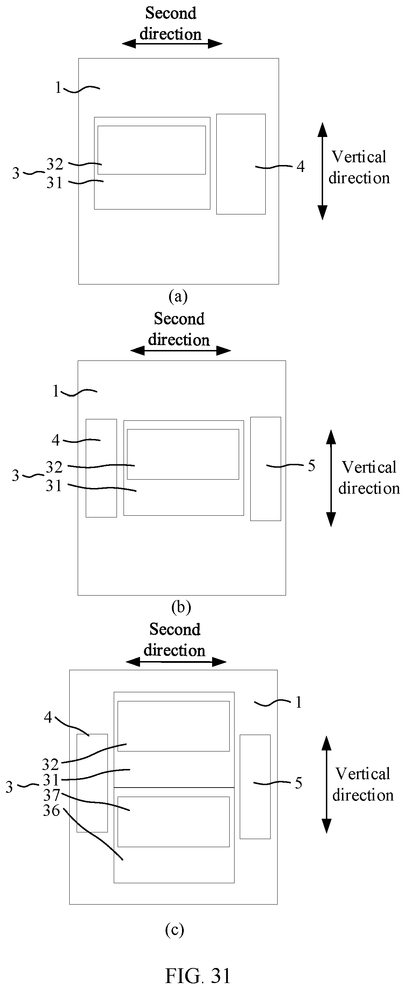

When the first heat exchanger 4 includes the heat conducting plate 43, the plurality of first heat dissipation fins 441, and the plurality of second heat dissipation fins 442, in the examples shown in FIG. 28 to FIG. 30, the first heat exchanger 4 and the heat sink 3 are arranged in the vertical direction. For example, the first heat exchanger 4 is located below the heat sink 3. In some other examples, the first heat exchanger 4 and the heat sink 3 may alternatively be arranged in a horizontal direction (for example, the second direction). FIG. 31 shows an example of various positions of the first heat exchanger. With reference to (a) in FIG. 31, the first heat exchanger 4 may be disposed on one side of the heat sink 3 in the second direction. With reference to (b) and (c) in FIG. 31, one through opening 115 is provided on each of two sides of the heat sink 3 in the second direction (for a structure of the through opening 115, refer to any one of FIG. 28 to FIG. 30). One first heat exchanger 4 passes through the through opening 115 on one side of the heat sink 3, and one second heat exchanger 5 (a structure of the second heat exchanger 5 is the same as that of the first heat exchanger 4) passes through the through opening 115 on the other side of the heat sink 3. Alternatively, one first heat exchanger 4 passes through each through opening 115 (one first heat exchanger 4 is disposed on each of the two sides of the heat sink 3 in the second direction).

In some examples, the first substrate 31 may be integrally connected to the second substrate 36. In another example, the first substrate 31 and the second substrate 36 may be separately disposed and then fastened together (directly fastened or indirectly fastened through another structure).

In some examples, the first heat exchanger 4 and the first substrate 31 may be separately disposed and then mounted in the heat dissipation cavity 112. In another example, the first heat exchanger 4 may be integrally connected to the first substrate 31.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion device, comprising a housing, a circuit board, a heat sink, and a first heat exchanger, wherein
a sealed power cavity is formed inside the housing, an open and ventilated heat dissipation cavity is formed outside the housing, the housing comprises a separator located between the power cavity and the heat dissipation cavity, a protection rating of the power cavity is higher than that of the heat dissipation cavity, the separator is provided with an opening, the circuit board is disposed in the power cavity, a first power component is mounted on a side that is of the circuit board and that faces the opening, and the first power component forms a power conversion circuit of the power conversion device, to perform power conversion on a direct current input to the power conversion device;
the heat sink is disposed in the heat dissipation cavity and comprises a first substrate and a first heat dissipation portion, the first substrate is disposed at the opening and is in thermal contact with the first power component in the power cavity, the first heat dissipation portion extends outward from the first substrate, a first gas-liquid channel is disposed in the first substrate, a second gas-liquid channel communicating with the first gas-liquid channel is disposed in the first heat dissipation portion, a cooling medium used for gas-liquid conversion is disposed in the first gas-liquid channel, and an included angle between the first gas-liquid channel and the second gas-liquid channel is 90 degrees or is greater than 90 degrees and less than 180 degrees; and
an electronic component is mounted on a side that is of the circuit board and that is opposite to the side on which the first power component is mounted, the first heat exchanger is located in the power cavity or the heat dissipation cavity, and the first heat exchanger is configured to transfer heat in the power cavity to the heat dissipation cavity, to dissipate heat for the electronic component.

2. The power conversion device according to claim 1, wherein the first substrate extends in a vertical direction and protrudes from the first heat dissipation portion, and the first power component is in thermal contact with a part that is of the first substrate and that protrudes from the first heat dissipation portion.

3. The power conversion device according to claim 1 or 2, wherein the first heat exchanger is located in the power cavity, a first heat exchange channel is formed in the first heat exchanger, the first heat exchange channel is isolated from the power cavity, the first heat exchange channel has an inlet and an outlet that are provided on the first heat exchanger, and both the inlet and the outlet of the first heat exchange channel communicate with the heat dissipation cavity; or the first heat exchanger is located in the heat dissipation cavity, a first heat exchange channel is formed in the first heat exchanger, the first heat exchange channel is isolated from the heat dissipation cavity, the first heat exchange channel has an inlet and an outlet that are provided on the first heat exchanger, and both the inlet and the outlet of the first heat exchange channel communicate with the power cavity.

4. The power conversion device according to claim 3, wherein the first substrate extends in the vertical direction and protrudes from the first heat dissipation portion, and the first heat exchanger crosses the first substrate and overlaps the part that is of the first substrate and that protrudes from the first heat dissipation portion.

5. The power conversion device according to claim 1 or 2, wherein the first heat exchanger is located in the heat dissipation cavity, the first heat exchanger comprises a heat conducting plate and a heat dissipation fin that are connected to each other, the heat conducting plate is thermally attached to the first substrate, a first fan is disposed in the heat dissipation cavity, and the first fan is configured to generate airflow to pass through the heat dissipation fin.

6. The power conversion device according to claim 5, wherein the first substrate extends in the vertical direction and protrudes from the first heat dissipation portion, the heat conducting plate is thermally attached to the part that is of the first substrate and that protrudes from the first heat dissipation portion, and the heat dissipation fin is located below the first heat dissipation portion.

7. The power conversion device according to claim 1 or 2, wherein the separator is provided with a through opening, the first heat exchanger comprises a heat conducting plate and a plurality of heat dissipation fins, the plurality of heat dissipation fins comprise a first heat dissipation fin and a second heat dissipation fin, the heat conducting plate is disposed at the through opening, and the first heat dissipation fin and the second heat dissipation fin are fastened to different surfaces of the heat conducting plate;
the heat conducting plate and the first heat dissipation fin are located in the heat dissipation cavity, and the second heat dissipation fin extends into the power cavity through the through opening; or the heat conducting plate and the second heat dissipation fin are located in the power cavity, and the first heat dissipation fin extends into the heat dissipation cavity through the through opening; and
a second fan is disposed in the power cavity, and is configured to generate airflow to pass through the second heat dissipation fin.

8. The power conversion device according to claim 1, wherein the power cavity and the heat dissipation cavity are distributed in a first direction, the first direction is perpendicular to a vertical direction, the heat sink further comprises a second substrate and a second heat dissipation portion, the second substrate and the first substrate are distributed in the vertical direction and fastened together, the second heat dissipation portion extends outward from the second substrate, a third gas-liquid channel is disposed in the second substrate, a fourth gas-liquid channel communicating with the third gas-liquid channel is disposed in the second heat dissipation portion, the third gas-liquid channel is isolated from the first gas-liquid channel, a second power component is disposed on the side that is of the circuit board and that faces the opening, the second power component is in contact with the second substrate in the heat dissipation cavity, and a cooling medium used for gas-liquid conversion is disposed in the third gas-liquid channel.

9. The power conversion device according to claim 8, wherein the power conversion device further comprises a second heat exchanger, the second heat exchanger is configured to transfer the heat in the power cavity to the heat dissipation cavity, and both the first heat exchanger and the second heat exchanger are disposed in the heat dissipation cavity; and
the first heat dissipation portion and the second heat dissipation portion are distributed in the vertical direction, the first substrate protrudes downward from the first heat dissipation portion, the second substrate protrudes downward from the second heat dissipation portion, one of the first heat exchanger and the second heat exchanger is located between the first heat dissipation portion and the second heat dissipation portion, and the other is located below the lower one of the first heat dissipation portion and the second heat dissipation portion.

10. The power conversion device according to claim 9, wherein a first heat exchange channel is formed in the first heat exchanger, a second heat exchange channel is formed in the second heat exchanger, both an inlet of the first heat exchange channel and an inlet of the second heat exchange channel communicate with a first connecting pipe, both an outlet of the first heat exchange channel and an outlet of the heat exchange channel communicate with a second connecting pipe, and both the first connecting pipe and the second connecting pipe are located in the heat dissipation cavity and communicate with the power cavity.

11. The power conversion device according to claim 10, wherein both the first heat exchange channel and the second heat exchange channel extend in a second direction;
the first connecting pipe and the second connecting pipe are located on different sides of the lower one of the first heat dissipation portion and the second heat dissipation portion in the second direction; and
the first direction, the second direction, and the vertical direction are perpendicular to each other.

12. The power conversion device according to any one of claims 8 to 11, wherein the power conversion device further comprises a protective cover, the heat dissipation cavity is formed inside the protective cover, the protective cover is provided with a heat dissipation hole, the heat dissipation hole comprises an air inlet hole and an air outlet hole, one of the air inlet hole and the air outlet hole is located below the heat sink, the other is located above the heat sink, a first fan is disposed in the heat dissipation cavity, and the first fan is configured to drive air that enters through the air inlet hole to be discharged from the air outlet hole.

13. The power conversion device according to claim 12, wherein the first heat dissipation portion comprises a plurality of first condensation pipes arranged at intervals, the second heat dissipation portion comprises a plurality of second condensation pipes arranged at intervals, and a plurality of fins are disposed between two adjacent ones of the first condensation pipes and between two adjacent ones of the second condensation pipes; and
in the first heat dissipation portion and the second heat dissipation portion, a quantity of fins disposed on the one close to the air inlet hole is less than a quantity of fins disposed on the one away from the air inlet hole.

14. The power conversion device according to claim 12 or 13, wherein in the first heat dissipation portion and the second heat dissipation portion, a dimension of the one close to the air inlet hole in the first direction is less than a dimension of the one away from the air inlet hole in the first direction.

15. The power conversion device according to any one of claims 1 to 14, wherein the included angle between the first gas-liquid channel and the second gas-liquid channel is greater than 90 degrees and less than or equal to 160 degrees.

16. The power conversion device according to any one of claims 1 to 15, wherein the first power component is fastened to the first substrate through a bolt, the circuit board is provided with a through hole, the through hole is used for a head portion of the bolt to pass through, a rod portion of the bolt passes through the first power component and is threaded to the first substrate, and the head portion of the bolt abuts against a surface that is of the first power component and that is away from the first substrate.

17. The power conversion device according to any one of claims 1 to 16, wherein an inner wall surface that is of the first substrate and that encloses the first gas-liquid channel comprises a first wall surface and a second wall surface, the first wall surface and the second wall surface are disposed opposite to each other in a thickness direction of the first substrate, a plurality of support members are disposed between the first wall surface and the second wall surface, and each of the support members has one end connected to or abutting against the first wall surface and the other end connected to or abutting against the second wall surface.

18. The power conversion device according to claim 17, wherein the first substrate comprises a bottom plate and a cover plate that are arranged in the first direction, the bottom plate is connected to the first power component, the cover plate is located on a side that is of the bottom plate and that is away from the first power component, an edge of the cover plate is fastened to an edge of the bottom plate, the cover plate bulges toward a side away from the bottom plate, and the first gas-liquid channel is located between the cover plate and the bottom plate; and each of the support members has one end integrally connected to the bottom plate and the other end connected to or abutting against the cover plate; and
the plurality of support members are divided into a plurality of rows of support groups arranged in the vertical direction, the support group in each row comprises a plurality of support members arranged in the second direction, and the first direction, the second direction, and the vertical direction are perpendicular to each other; a flow equalization channel extending in the second direction is formed between the support groups in two adjacent rows, and the flow equalization channel communicates with the second gas-liquid channel; and surfaces that are of the plurality of support members in the support group in each row and that face upward in the vertical direction are flush, surfaces that are of the plurality of support members in the support group in each row and that face downward in the vertical direction are flush, and for each of the support members, the surface facing upward in the vertical direction is parallel to the surface facing downward in the vertical direction.

19. The power conversion device according to any one of claims 1 to 18, wherein the heat sink further comprises a confluence portion, the confluence portion is disposed in the heat dissipation cavity and connected to an end that is of the first heat dissipation portion and that is away from the first substrate, the second gas-liquid channel comprises a plurality of subchannels, and a confluence channel communicating with the different subchannels in the second gas-liquid channel is disposed in the confluence portion, so that the different subchannels in the second gas-liquid channel communicate with each other.

20. The power conversion device according to claim 19, wherein the heat sink further comprises a return pipe, the return pipe is disposed below the first heat dissipation portion, and the return pipe has one end communicating with the first gas-liquid channel and the other end communicating with the confluence channel.

21. The power conversion device according to claim 19 or 20, wherein the confluence portion comprises a first plate and a second plate, an edge of the first plate is fastened to an edge of the second plate, the first plate is connected to the end that is of the first heat dissipation portion and that is away from the first substrate, the second plate is located on a side that is of the first plate and that is away from the first heat dissipation portion, the second plate bulges toward a side away from the first plate, and the confluence channel is located between the first plate and the second plate; and
the second plate is provided with a plurality of concave structures, the plurality of concave structures are concave into the confluence channel in a direction close to the first plate, and the plurality of concave structures abut against the first plate.

22. The power conversion device according to any one of claims 1 to 21, wherein a first evaporation zone is disposed in the first gas-liquid channel, a side that is of the first evaporation zone and that faces the first power component is connected to the inner wall surface of the first substrate, an outer wall surface corresponding to the inner wall surface that is of the first substrate and that is connected to the first evaporation zone is in contact with the first power component, the first gas-liquid channel comprises a first cavity and a second cavity that are located on two sides of the first evaporation zone in the vertical direction, and a plurality of first flow channels communicating with the first cavity and the second cavity are disposed in the first evaporation zone.

23. The power conversion device according to claim 22, wherein second evaporation zones are disposed on two sides of the first evaporation zone, a distribution direction of the two second evaporation zones is perpendicular to the vertical direction, a plurality of second flow channels communicating with the first cavity and the second cavity are disposed in the second evaporation zone, and a quantity of the second flow channels in each of the second evaporation zones is less than a quantity of the first flow channels.
